# EUROPEAN PATENT APPLICATION

(11) **EP 4 819 369 A1**
(43) Date of publication of application: **07.10.2026**
(21) Application number: 25755833.8
(22) Date of filing: 23.01.2025
(51) Int. Cl.: H01M 50/569, H01M 10/42, H01M 10/48, H01M 50/298

(54) **BATTERY DEVICE AND ELECTRIC DEVICE**

(71) Applicant: Contemporary Amperex Technology Co., Limited, Jiaocheng District Ningde Fujian 352100 (CN)
(72) Inventor: WANG, Yalei, Ningde, Fujian 352100 (CN); ZHOU, Huiping, Ningde, Fujian 352100 (CN); QIN, Feng, Ningde, Fujian 352100 (CN); WANG, Peng, Ningde, Fujian 352100 (CN)
(74) Representative: Gong, Jinping
(86) International application number: PCT/CN2025/074347
(87) International publication number: WO 2026/156607

(57) **Abstract**

Disclosed herein is a battery device (100), including a battery cell assembly (20) and a sampling assembly (80). The battery cell assembly (20) includes a plurality of battery cells (30) sequentially connected in series. The sampling assembly (30) includes a plurality of sampling parts, a plurality of connection wire harnesses (70), and an output port (921). Each sampling part is electrically connected to at least one connection wire harness (70), a plurality of the connection wire harnesses (70) are all connected to the output port (921). The plurality of sampling parts include a first sampling part (81) and a second sampling part (82). The first sampling part (81) and the second sampling part (30) are provided with a sampling point that can be electrically connected to the series path of the battery cells (30). The number of the first sampling parts (81) is two, and the two first sampling parts (81) are separately and electrically connected to the battery cell (30) at the front and the battery cell (30) at the rear of a plurality of the battery cells (30) sequentially connected in series. In the series path of a plurality of the battery cells (30), the number of the battery cells (30) between the sampling points of at least two adjacent second sampling parts (82) is greater than or equal to two.

## Description

### TECHNICAL FIELD

The present application relates to the field of battery technology, and in particular, to a battery device and an electric device.

### BACKGROUND

In the related art, a battery device generally includes a plurality of battery cells arranged in a case. In order to collect parameters such as the voltage or current of the battery cells for reference by a battery management system, the end part of each battery cell is electrically connected to a battery monitoring unit. However, when an excessive number of battery cells are present, the electrical connection path between the battery cells and the battery monitoring unit may be redundant and complicated, which affects the further improvement of the energy density of the battery device.

### SUMMARY

In view of the above problem, the present application provides a battery device and an electric device, so as to at least improve the energy density of the battery device.

In a first aspect, the present application provides a battery device. The battery device includes a battery cell assembly and a sampling assembly, where:
the battery cell assembly includes a plurality of battery cells sequentially connected in series;
the sampling assembly includes a plurality of sampling parts, a plurality of connection wire harnesses, and an output port, where each sampling part is electrically connected to at least one connection wire harness, a plurality of the connection wire harnesses are all connected to the output port, the plurality of sampling parts include a first sampling part and a second sampling part, and the first sampling part and the second sampling part are provided with a sampling point that can be electrically connected to the series path of the battery cells; the number of the first sampling parts is two, and the two first sampling parts are separately and electrically connected to the battery cell at the front and the battery cell at the rear of a plurality of the battery cells sequentially connected in series; in the series path of a plurality of the battery cells, the number of the battery cells between the sampling points of at least two adjacent second sampling parts is greater than or equal to two.

In the above technical solution, the sampling points of the two adjacent second sampling parts in the series path of a plurality of the battery cells may acquire parameters of the battery cells between the two sampling points. There are at least two adjacent second sampling parts in the battery device that can acquire parameters of two or more battery cells, such that the number of the sampling parts may be correspondingly reduced, and thus the wire harness connected to the sampling parts may also be shortened and simplified, thereby saving the mounting space, improving the energy density of the battery device and the cost-efficiency to a certain extent.

According to some embodiments of the present application, optionally, in the series path of a plurality of the battery cells, the number of the battery cells between the sampling points of every two adjacent second sampling parts is equal, and is greater than or equal to two.

In the above technical solution, in the series path of a plurality of the battery cells, when the number of the battery cells between the sampling points of every two adjacent second sampling parts is equal and greater than or equal to two, compared with the case that the sampling parts are separately arranged at both ends of each battery cell, the number of the sampling parts is reduced, and the sampling parts may be connected to the battery monitoring unit by using shortened wire harnesses, thus saving the mounting space and further improving the cost-efficiency to a certain extent.

According to some embodiments of the present application, optionally, in the series path of a plurality of the battery cells, one or more of the battery cells are provided between the sampling point of the first sampling part and the sampling point of the adjacent second sampling part.

In the above technical solution, in the series path of a plurality of the battery cells, the number of the battery cells between the sampling points of the adjacent second sampling parts may be one or more, thereby saving space and improving the sampling precision. The distribution positions of the sampling points may be flexibly adaptive to various arrangements of the battery cells.

According to some embodiments of the present application, optionally, a plurality of the battery cells are arranged in a first direction to form a battery row; the battery cell assembly includes at least one battery row; the sampling points of the two first sampling parts are separately located on two sides of the battery cell assembly in a second direction; the sampling points of the second sampling parts are distributed on the same side or different sides of the battery row in the second direction; the second direction and the first direction form an included angle.

In the above technical solution, the sampling points of the two first sampling parts are separately located on the two sides of the battery cell assembly in the second direction, and in the series path of a plurality of the battery cells, the number of the battery cells between the sampling points of the adjacent second sampling parts may be one or more, thereby saving space, ensuring the parameter acquisition of all the battery cells, and improving the sampling precision to a certain extent.

According to some embodiments of the present application, optionally, a plurality of battery rows are present, a plurality of the battery rows are arranged in the second direction and/or a third direction, and the sampling points of the second sampling parts are distributed at least on one side of one of the battery rows in the arrangement direction thereof; every two of the first direction, the second direction, and the third direction form an included angle.

In the above technical solution, the sampling points of the second sampling parts are at least distributed on one side of one of the battery rows in its arrangement direction, thereby saving the mounting space of the sampling assembly. The distribution positions of the sampling points may be flexibly adaptive to various arrangements of the battery cells.

According to some embodiments of the present application, optionally, the number of the battery rows is two, and the two battery rows are arranged in the second direction; the sampling points of the second sampling parts are distributed between the two battery rows.

In the above technical solution, the sampling points of the second sampling parts are distributed between two adjacent battery rows to concentrate the positions of the second sampling parts and help save the mounting space of the sampling assembly, thus facilitating the wiring and assembly.

According to some embodiments of the present application, optionally, the number of the battery rows is two, and the two battery rows are arranged in the second direction; the sampling points of the second sampling parts are distributed on the two sides of one of the battery rows in the second direction.

In the above technical solution, the sampling points of the second sampling parts are distributed on the two sides of one of the battery rows in the second direction, and each battery cell in the battery row may be sampled individually, thus locally improving the sampling precision and facilitating the battery management system to accurately adjust the battery management strategy according to the sampling parameters.

According to some embodiments of the present application, optionally, the battery device includes a battery monitoring unit; each of the battery cells is electrically connected to the battery monitoring unit through the connection wire harness; the connection wire harness includes a first end part and a second end part that are opposite; the first end part forms the sampling part, and the second end part is electrically connected to the battery monitoring unit.

In the above technical solution, at least one conductive part of each battery cell is electrically connected to the battery monitoring unit through the connection wire harness, and the second end part of the connection wire harness forms the sampling part and is connected to the conductive part, such that the battery monitoring unit may acquire parameters of each battery cell through the sampling part and the connection wire harness, thereby improving the sampling precision and facilitating the battery management system to accurately adjust the battery management strategy.

According to some embodiments of the present application, optionally, the second end part and the battery monitoring unit are connected by welding.

In the above technical solution, the second end part and the battery monitoring unit are connected by welding, thus helping reduce the number of the adapting members and wire harnesses and saving the mounting space.

According to some embodiments of the present application, optionally, the second end part is connected to the output port; the battery monitoring unit is provided with a connector, and the output port is connected to the connector by means of plug-in.

In the above technical solution, the second end part is connected to the battery monitoring unit through the output port and the connector by means of plug-in, thereby improving the connection reliability of the connection wire harness and the battery monitoring unit.

According to some embodiments of the present application, optionally, the battery device includes an electrical connection member, a first patch cable, and a second patch cable; the first patch cable and the second patch cable are both connected to the electrical connection member; the second end parts of a plurality of the connection wire harnesses are connected to the electrical connection member through the corresponding first patch cable, and the end of the second patch cable distal to the electrical connection member is connected to the output port and connected to the battery monitoring unit by means of plug-in.

In the above technical solution, the second end parts of the connection wire harnesses are connected to the electrical connection member through the corresponding first patch cable, and the end of the second patch cable distal to the electrical connection member is connected to the battery monitoring unit, such that the connection wire harnesses are gathered before being connected to the battery monitoring unit, thus simplifying the electrical connecting lines between the connection wire harnesses and the battery monitoring unit, saving the mounting space, and facilitating the recognition, assembly and maintenance.

According to some embodiments of the present application, optionally, the end of the second patch cable distal to the electrical connection member is connected to the output port; the battery monitoring unit is provided with a connector, and the output port is connected to the connector by means of plug-in.

In the above technical solution, the end of the second patch cable distal to the electrical connection member is connected to the output port, the battery monitoring unit is provided with a connector, and the output port is connected to the connector by means of plug-in, such that the circuit connection or disconnection between the battery monitoring unit and the second patch cable may be achieved through the plug-in and plug-off of the output port or the connector, thus featuring ease of operation.

According to some embodiments of the present application, optionally, a plurality of the battery cells are arranged in the first direction to form the battery row; the number of the battery rows is at least two, and at least two of the battery rows are arranged in the second direction; the battery monitoring unit is disposed on one side of all the battery rows or between two adjacent battery rows in the second direction; the first direction and the second direction are disposed with an included angle.

In the above technical solution, a plurality of the battery cells are arranged in the first direction to form the battery row, and the number of the battery rows is at least two, such that the overall output voltage of the battery device can be increased. In the second direction, the battery monitoring unit is disposed between two battery cell assemblies or on one side of all battery cell assemblies to make the structure compact, thus saving the space in the second direction.

According to some embodiments of the present application, optionally, the battery cell includes a housing and conductive parts; the conductive parts are provided at end parts of the housing in the second direction, and the conductive parts of two adjacent battery cells in the second direction are connected; the first end part is connected to a part of the conductive parts to form the sampling part.

In the above technical solution, the conductive parts of two adjacent battery cells arranged in the second direction are connected, such that the electrical connection member between the battery cells may be omitted or reduced, thus reducing the number of parts in the battery cell assembly, saving the space occupied by the electrical connection members, and helping improve the energy density of the battery cell assembly. The conductive parts are connected to the first end part of the connection wire harness to form the sampling part, thus simplifying the structure of the sampling part.

According to some embodiments of the present application, optionally, the first end part is welded or bonded to the conductive part.

In the above technical solution, by welding or bonding the first end part of the connection wire harness to the conductive part, the first end part forms the sampling part, and the second end part is electrically connected to the battery monitoring unit, such that the first end part of the connection wire harness may sample the voltage of a connected battery cell and transmit the voltage information acquired by sampling to the battery monitoring unit through the second end part, thus ensuring the accuracy and stability of sampling. The connection wire harness achieves the voltage sampling while achieving the electrical connection, and thus may save the number of parts and the mounting space.

According to some embodiments of the present application, optionally, a corner space is formed at a corner of the housing in the third direction; the connection wire harness is at least partially located in the corner space and extends in the second direction; every two of the first direction, the second direction, and the third direction are disposed with an included angle.

In the above technical solution, a delivery space is formed at a corner of the housing in the third direction, the connection wire harness is at least partially located in the corner space and extends in the second direction, and the corner of the housing in the third direction also extends in the second direction, such that the connection wire harness may extend in the corner space, thereby making full use of the volume space occupied by the battery cell to accommodate the connection wire harness and improving the space utilization.

According to some embodiments of the present application, optionally, the connection wire harness is at least one of a flexible circuit board and a wire harness.

In the above technical solution, the connection wire harness is at least one of a flexible circuit board and a wire harness. The good flexibility of the connection wire harness allows the arrangement of the connection wire harness in the irregular structural space between the end parts of the plurality of housings and the battery monitoring unit, thus featuring good adaptability and saving the mounting space of the connection wire harness.

According to some embodiments of the present application, optionally, all the conductive parts located on the same side of a plurality of the battery cells of the battery cell assembly are sequentially arranged in the first direction; in the third direction, a plurality of the conductive parts and the end part of the battery cell assembly form an accommodating gap, and the battery monitoring unit is disposed in the accommodating gap.

In the above technical solution, all the conductive parts located on the same side of a plurality of the battery cells are sequentially arranged in the first direction and form an accommodating gap with the end part of the battery cell assembly in the third direction, and the battery monitoring unit is disposed in the accommodating gap and connected to the conductive part, such that the battery monitoring unit can utilize the accommodating gap as the mounting space, making the structure of the battery device more compact, saving space, and further helping improve the energy density of the battery device.

According to some embodiments of the present application, optionally, the battery device includes the battery monitoring unit and the electrical connection member; the electrical connection member is disposed in the accommodating gap, located between the conductive part and the battery monitoring unit, and electrically connected to the battery monitoring unit and the conductive part.

In the above technical solution, the electrical connection member is located between the conductive part and the battery monitoring unit and connected to the conductive part and the battery monitoring unit, such that the conductive parts of the plurality of battery cells may be connected to the battery monitoring unit through the electrical connection member, thus further utilizing the space of the accommodating gap in the third direction, making the structure more compact, and saving the mounting space required by the battery monitoring unit while achieving the electrical connection between the battery monitoring unit and the plurality of battery cells.

According to some embodiments of the present application, optionally, the battery device includes a master control board, and the battery monitoring unit is electrically connected to the master control board.

In the above technical solution, the battery device includes a master control board, and the battery monitoring unit is electrically connected to the master control board and may acquire parameters of the battery cell, such that the master control board may accurately and reliably acquire the parameters of the battery cell, and timely adjust the control strategy for the battery device according to the state of the battery cell.

According to some embodiments of the present application, optionally, the battery device includes a case including a bottom plate, and the accommodating gap is located between the bottom plate and the conductive part.

In the above technical solution, the battery cell assembly is accommodated in the battery device through the case, the case may provide support and protection for the battery cell, and the accommodating gap is located between the bottom plate of the case and the conductive part, such that the boundary range of the accommodating gap in the third direction is clear, and the bottom plate may provide support for the battery monitoring unit in the accommodating gap, making the battery monitoring unit mounted more stably in the accommodating gap.

According to some embodiments of the present application, optionally, the battery device includes a support connected to the case, and the battery monitoring unit is mounted to the support.

In the above technical solution, the support is connected to the case, and the battery monitoring unit is mounted to the support, such that the battery monitoring unit may be connected to the case through the support, thus improving the mounting stability and reliability of the battery monitoring unit and helping improve the integral rigidity and strength of the battery device.

According to some embodiments of the present application, optionally, the battery monitoring unit is bonded to a case wall of the case.

In the above technical solution, the battery monitoring unit is bonded to the case wall of the case, such that the battery monitoring unit is integrally connected to the case wall of the case, thus facilitating the integration of the battery monitoring unit with the case, saving space, helping with the assembly of parts in the battery device, and further contributing to the insulation, isolation and protection between the battery monitoring unit and the case.

According to some embodiments of the present application, optionally, the length of the battery monitoring unit extends in the first direction.

In the above technical solution, the length of the battery monitoring unit extends in the first direction, and the accommodating gap also extends in the first direction, such that the space where the accommodating gap is located can be fully filled with the battery monitoring unit, thus improving the space utilization.

According to some embodiments of the present application, optionally, the housing is made of a soft outer packaging material; in the first direction, a reinforcing partition plate is sandwiched between at least two adjacent battery cells and connected to the housing; the hardness of the reinforcing partition plate is greater than that of the housing.

In the above technical solution, disposing a reinforcing partition plate between adjacent battery cells and providing the reinforcing partition plate with a hardness greater than that of the flexible shell can conveniently achieve the assembly of a plurality of battery cells and improve the overall rigidity of the battery cell assembly formed by the assembly of the plurality of battery cells, thus facilitating the mounting of the battery cell assembly formed by the assembly of the plurality of battery cells and reducing the deformation of the battery cells after the assembly.

According to some embodiments of the present application, optionally, the thickness of the reinforcing partition plate is less than that of the battery cell.

In the above technical solution, providing the reinforcing partition plate with a thickness less than that of the battery cell may reduce the occupied space of the reinforcing partition plate, especially the occupied space of the reinforcing partition plate in the thickness direction of the battery cell, while improving the overall rigidity of the assembly of the plurality of battery cells, so as to increase the overall energy density of the battery device.

According to some embodiments of the present application, optionally, the reinforcing partition plate is a metal plate.

In the above technical solution, by configuring the reinforcing partition plate with an aluminum plate, an aluminum alloy plate, a copper plate, a steel plate, or the like, the reinforcing partition plate may have high strength and hardness, thus better improving the overall rigidity of the assembly of the plurality of battery cells and better reducing the deformation of the assembled battery cells.

According to some embodiments of the present application, optionally, the reinforcing partition plate is a thermally conductive member and is thermo-conductively connected to the housing.

In the above technical solution, by configuring the reinforcing partition plate as a thermally conductive member and thermo-conductively connecting same to the housing, the reinforcing partition plate may have heat management functionality, while enhancing the overall rigidity of the assembly of the battery cells. Through the heat exchange of the reinforcing partition plate and the battery cells, the temperature of the battery cells can be adjusted, making the battery cells work in a proper temperature range.

According to some embodiments of the present application, optionally, the reinforcing partition plate is of a solid structure.

In the above technical solution, the configuration of the reinforcing partition plate into a solid structure may provide the reinforcing partition plate with good structural strength and rigidity, and allows the reinforcing partition plate to effectively exert the reinforcing effects with a lower reinforcing partition plate thickness, thus providing a high volumetric energy density while providing the battery cell assembly with good strength and rigidity.

According to some embodiments of the present application, optionally, a cavity is formed in the reinforcing partition plate.

In the above technical solution, the arrangement of the cavity in the reinforcing partition plate provides clearance for the expansion and deformation of the battery cells while allowing the reinforcing partition plate to enhance the overall rigidity of the assembled battery cells. The cavity in the reinforcing partition plate may buffer the deformation of the adjacent battery cells and is desirable for reducing the weight of the reinforcing partition plate.

According to some embodiments of the present application, optionally, the cavity includes a heat exchange flow channel for the flow of a heat exchange medium.

In the above technical solution, at least a part of the cavity in the reinforcing partition plate forms the heat exchange flow channel. The heat exchange medium may flow through the heat exchange flow channel in the reinforcing partition plate and exchange heat with the battery cell, so as to achieve the effective adjustment of the temperature of the battery cells.

According to some embodiments of the present application, optionally, the reinforcing partition plate includes a connecting part protruding from the housing in the second direction, and the connecting part is located on the side of the conductive part distal to the battery monitoring unit.

In the above technical solution, by configuring the end part of the reinforcing partition plate in the second direction to protrude from the housing of the battery cell and connecting same to the case, since the reinforcing partition plate is sandwiched between the plurality of battery cells and forms the battery cell assembly with the plurality of battery cells and the hardness of reinforcing partition plate is generally greater than that of the housing of battery cell, the battery cell assembly generally possesses good strength and rigidity.

According to some embodiments of the present application, optionally, in the first direction, two adjacent reinforcing partition plates are connected by a connecting plate, and the battery cell is accommodated in a space defined by the connecting plate and the two reinforcing partition plates in an enclosing manner.

In the above technical solution, two adjacent reinforcing partition plates are connected by a connecting plate, and the battery cell is accommodated in a space defined by the connecting plate and the two reinforcing partition plates in an enclosing manner, thereby improving the strength of the reinforcing partition plates and further increasing the mounting reliability and the stability of battery cells.

According to some embodiments of the present application, optionally, the two adjacent reinforcing partition plates in the first direction, along with the connecting plate connected thereto, are integrally formed.

In the above technical solution, the two adjacent reinforcing partition plates in the first direction and the connecting plate connected between the two reinforcing partition plates are molded into an integral structure, so as to further increase the strength of the reinforcing partition plate and improve the mounting reliability and the structural stability of the battery cells.

According to some embodiments of the present application, optionally, the conductive parts of the two adjacent battery cells are directly connected.

In the above technical solution, the direct connection of the conductive parts of two adjacent battery cells in the battery cell assembly may omit or reduce the electrical connection member between the battery cells, thus reducing the number of parts in the battery cell assembly, saving the space occupied by the electrical connection members, and helping improve the energy density of the battery cell assembly. The omission or reduction of the electrical connection member between the battery cells may further improve the cost-efficiency.

According to some embodiments of the present application, optionally, the conductive parts of the two adjacent battery cells are connected by welding.

In the above technical solution, the welding connection between the conductive parts of the two adjacent battery cells in the battery cell assembly achieves the direct connection of the terminals of the two adjacent battery cells in the battery cell assembly, thus providing a simple and reliable connection of the conductive parts of the two adjacent battery cells in the battery cell assembly.

According to some embodiments of the present application, optionally, the conductive parts of the two adjacent battery cells are directly connected by a conductive adhesive.

In the above technical solution, the connection of the conductive parts of the two adjacent battery cells in the battery cell assembly through a conductive adhesive achieves the direct connection of the terminals of the two adjacent battery cells in the battery cell assembly, thus providing a simple and reliable connection of the conductive parts of the two adjacent battery cells in the battery cell assembly.

According to some embodiments of the present application, optionally, a plurality of the battery cells are sequentially coupled by bonding in the first direction; the battery cell is provided with a first surface and a second surface, and the second surface is adjacent to the first surface;

the battery device includes the case, an adhesive layer, and a blocking member; the adhesive layer is arranged on the side of the first surface of the battery cell assembly and configured for bonding a plurality of the battery cells to the case; the blocking member is at least located between at least one of the battery cells at the two ends of the battery cell assembly in the first direction and the adhesive layer, and configured for preventing the adhesive layer from overflowing from the first surface of the battery cell to the second surface of the corresponding battery cell.

In the above technical solution, the arrangement of the blocking member between at least one battery cell at least located at two ends of the battery cell assembly in the first direction and the adhesive layer can reduce the risk that the adhesive overflows from the first surface of the battery cell to the second surface when applying the adhesive in the assembly stage of the battery device, and reduce the probability that the adhesive overflows from the second surface of the battery cell to form a hard structure, thus alleviating the problem of concentrated local stress on the surface of the battery cell and the risk of damage to the battery cell, and improving the insulation between the first surface of the battery cell and the case, the reliability of the battery cell, and the reliability of the battery device.

According to some embodiments of the present application, optionally, the blocking member covers at least a corner position of the corresponding battery cell.

In the above technical solution, by covering the corner position of the corresponding battery cell with the blocking member, the probability that the adhesive accumulates at the corner position of the outermost battery cell can be effectively reduced, thus achieving the effect of preventing adhesive overflow, reducing the size of the blocking member and materials, saving a proper space on the first surface for applying the adhesive, and improving the bonding fastness of battery cell and case.

According to some embodiments of the present application, optionally, the blocking member covers at least an edge position of the corresponding battery cell in the first direction.

In the above technical solution, the blocking member may reduce the risk that the adhesive overflows to the second surface of the battery cell with a greater area, thus further reducing the risk of adhesive overflow at the edge of battery cell assembly, the formation of a hard structure and damage to the battery cell, and improving the reliability of the battery device.

According to some embodiments of the present application, optionally, one blocking member is disposed between two adjacent battery cells in the first direction.

In the above technical solution, the blocking member is arranged between the two adjacent battery cells, and the blocking member may block the adhesive possibly overflowing when the two opposite first surfaces of the two adjacent battery cells are coated with the adhesive, thus reducing the number of the blocking members, simplifying the parts, and saving the occupied space.

According to some embodiments of the present application, optionally, the battery cell is any one of a lithium iron phosphate battery cell, a ternary battery cell, and a solid-state battery cell.

In the above technical solution, battery cells of the above types may provide more options for the design of the battery device to meet different requirements of use. When the battery cell is a lithium iron phosphate battery cell, it may feature advantages of high reliability, long cycle life, light weight, large capacity, and small internal resistance; when the battery cell is a ternary battery cell, it may feature advantages of higher energy density and good electrochemical performance; when the battery cell is a solid-state battery cell, it may feature advantages of high energy density, high reliability, light weight and good high/low temperature performance.

In a second aspect, the embodiments of the present application provide an electric device, including the battery device according to any one of the above embodiments, where the battery device is configured for providing electric energy.

In the electric device of the technical solution of the present application, at least two adjacent second sampling parts can acquire parameters of two or more battery cells, such that the total number of the sampling parts may be correspondingly reduced, and the connection wire harness may also be shortened and simplified, thereby saving space and improving the energy density of the battery device and the cost-efficiency to a certain extent.

The above description is only an overview of the technical solution of the present application. To more clearly understand the technical means of the present application to enable implementation in accordance with the content of the specification and to make the above and other purposes, features, and advantages of the present application more obvious and easy to understand, the detailed description of the present application is provided below.

### BRIEF DESCRIPTION OF THE DRAWINGS

By reading the detailed description of the preferred embodiments below, various additional advantages and benefits will become clear to those of ordinary skill in the art. The drawings are provided solely for the purpose of illustrating the preferred embodiments and shall not be construed as limiting the scope of the present application. Furthermore, the same reference numerals in all the drawings denote identical components. In the drawings:
FIG. 1 is a structural schematic view of a vehicle according to some embodiments of the present application;
FIG. 2 is a partial structural schematic view of a battery device according to some embodiments of the present application;
FIG. 3 is an enlarged schematic view of portion A in FIG. 2;
FIG. 4 is a three-dimensional structural schematic view of a battery cell according to some embodiments of the present application;
FIG. 5 is a structural schematic view of a battery cell in the first direction according to some embodiments of the present application;
FIG. 6 is a cross-sectional schematic view of a battery cell according to some embodiments of the present application;
FIG. 7 is a schematic view of a combination of a battery cell and a battery monitoring unit according to some embodiments of the present application;
FIG. 8 is a three-dimensional structure schematic view of a battery device according to some embodiments of the present application;
FIG. 9 is a schematic view of a battery device with the top cover removed according to some embodiments of the present application;
FIG. 10 is a schematic view of a battery device with the top cover removed according to some other embodiments of the present application;
FIG. 11 is an enlarged schematic view of portion B in FIG. 10;
FIG. 12 is a schematic view of a series path of a plurality of battery cells connected in series according to some embodiments of the present application;
FIG. 13 is a schematic view of a series path of a plurality of battery cells connected in series according to some other embodiments of the present application;
FIG. 14 is a schematic view of the connection of a battery monitoring unit and an electrical connection member according to some embodiments of the present application;
FIG. 15 is a structural schematic view of a battery cell assembly according to some embodiments of the present application;
FIG. 16 is an enlarged schematic view of portion C in FIG. 15;
FIG. 17 is a cross-sectional schematic view of a reinforcing partition plate according to some embodiments of the present application;
FIG. 18 is a schematic view of a combination of a reinforcing partition plate and a single battery cell according to some embodiments of the present application;
FIG. 19 is a schematic view of a battery cell assembly according to some embodiments of the present application;
FIG. 20 is a front view of the battery cell assembly in FIG. 19;
FIG. 21 is an enlarged view of portion D in FIG. 20;
FIG. 22 is an exploded view of a battery device according to another embodiment of the present application;
FIG. 23 is a partial structural schematic view of a battery device according to some embodiments of the present application;
FIG. 24 is a partial structural bottom view I of a battery device according to some embodiments of the present application; and
FIG. 25 is a partial structural bottom view II of a battery device according to one embodiment of the present application.

Reference numerals in the detailed description are as follows:
1000-vehicle; 100-battery device; 200-controller; 300-motor;
10-case; 10a-accommodating space; 101-case body; 102-heat exchange plate; 11-top cover; 12-bottom plate; 111-case wall; 17-support; 171-sub-support; 20-battery cell assembly; 201-accommodating gap; 202-battery row; 30-battery cell; 31-housing; 310-corner space; 311-first surface; 312-second surface; 33-conductive part; 331-lead-out part; 34-adhesive layer; 35-blocking member; 351-first part; 352-second part; 40-reinforcing partition plate; 41-connecting part; 42-cavity; 43-heat exchange flow channel; 44-connecting plate; 61-battery monitoring unit; 611-connector; 62-electrical connection member; 70-connection wire harness; 71-first end part; 72-second end part; 80-sampling assembly; 81-first sampling part; 82-second sampling part; 91-first patch cable; 92-second patch cable; 921-output port.

### DETAILED DESCRIPTION

Embodiments of the technical solutions of the present application will be described in detail below with reference to the drawings. The following embodiments are only for illustrating the technical solutions of the present application more clearly, and therefore are only exemplary and do not limit the claimed scope of the present application.

Unless otherwise defined, all technical and scientific terms used herein have the same meaning as commonly understood by those skilled in the technical field to which the present application belongs. The terms used herein are only for illustrating the specific embodiments, rather than limiting the present application. The terms "include", "comprise" and "provided with", and any variations thereof in the specification and claims of the present application and the above-mentioned drawing description encompass non-exclusive inclusions.

In the description of the embodiments of the present application, technical terms such as "first", "second", and the like are only used to distinguish different objects and should not be interpreted as indicating or implying the relative importance or implicitly indicating the number, specific order, or primary and secondary relationship of the noted technical features. In the description of the embodiments of the present application, unless otherwise specifically defined, "plurality of" means two or more.

Reference in the present application to "embodiment" means that a particular feature, structure, or characteristic described in combination with the embodiment can be included in at least one embodiment of the present application. The references of the word in the context of the specification do not necessarily refer to the same embodiment, nor to separate or alternative embodiments exclusive of other embodiments. It will be explicitly and implicitly appreciated by those skilled in the art that the embodiments described herein can be combined with other embodiments.

In the description of the embodiments of the present application, the term "and/or" is merely a way to describe the associative relationship between associated objects, indicating that there are three possible relationships. For example, "A and/or B" may denote: the presence of A alone, the simultaneous presence of A and B, and the presence of B alone. In addition, the character "/" herein generally indicates an "or" relationship between the associated objects before and after the "/".

In the description of the embodiments of the present application, the term "plurality of" refers to two or more. Similarly, "plurality of groups" refers to two or more groups, and "plurality of pieces" refers to two or more pieces.

In the description of the embodiments of the present application, the technical terms "center", "longitudinal", "transverse", "length", "width", "thickness", "upper", "lower", "front", "rear", "left", "right", "vertical", "horizontal", "top", "bottom", "inner", "outer", "clockwise" "counterclockwise", "axial", "radial", "circumferential" and the like indicating directional or positional relationships are based on the directional or positional relationships shown in the drawings and are merely for the convenience of describing the embodiments of the present application and simplifying the description, rather than indicating or implying that the noted devices or elements must have specific directions or must be constructed and operated in specific directions. Therefore, these terms should not be construed as limitations on the embodiments of the present application.

In the description of the embodiments of the present application, unless otherwise clearly specified and defined, the technical terms "mount", "interconnect", "connect", "fix", and the like should be interpreted in their broad senses. For example, "connect" may be "fixedly connect", "detachably connect", or "integrally connect"; "mechanically connect" or "electrically connect"; or "directly interconnect", "indirectly interconnect through an intermediate", "communication between interiors of two elements", or "interaction between two elements". For those of ordinary skill in the art, the specific meanings of the above terms in the embodiments disclosed in the present application may be interpreted according to the specific condition.

At present, judging from the development of the market situation, the application of power batteries is becoming broader. Power batteries are not only applied in energy storage power systems such as hydropower, thermal power, wind power and solar power stations, but are also widely applied in electric transportation vehicles such as electric bicycles, electric motorcycles, electric cars, as well as in military equipment, aerospace, and other fields. As the application of the power batteries becomes broader, the market demand thereof is also increasing.

With the expansion of the market and the development of technology, users may also have higher performance and safety requirements on power batteries. The power battery often needs frequent charge and discharge in the working process, and the charge and discharge process easily leads to excessive current or temperature or other problems, thus influencing the safety in use. The collection of voltage or current parameters of the battery and transmission to the battery management system (BMS) may provide reference to the control strategy of the BMS to timely and effectively protect the battery and thus becomes an important way for guaranteeing the use safety of the battery.

In the related art, a battery device generally includes a plurality of battery cells arranged in a case. In order to collect voltage or current of the battery cells for reference by the battery management system, the end part of each battery cell is electrically connected to a battery monitoring unit. However, the plurality of battery cells and the battery monitoring unit are electrically connected in a multi-to-one manner, which results in a relatively large space occupied by the sampling assembly (including but not limited to conducting wires, connectors, etc.) and the battery monitoring unit in the case, and further limits the increase of the energy density of the battery device.

In view of the above conditions, the present application provides a battery device, including a battery cell assembly and a sampling assembly. The battery cell assembly includes a plurality of battery cells connected in series, and the sampling assembly includes a plurality of sampling parts. In the series path of a plurality of the battery cells, the number of battery cells between sampling points of at least two adjacent sampling parts is greater than or equal to two, such that the number of sampling parts can be correspondingly reduced, thus reducing and simplifying the wire harnesses connected to the sampling parts, saving the mounting space, improving the energy density of the battery device and the cost-efficiency to a certain extent.

In the embodiments of the present application, the battery cell may be a secondary battery, which refers to a battery that may be continuously used by activating the active material by charging after the battery cell discharges.

The battery device (or battery apparatus) according to the embodiments of the present application may include a plurality of battery cell assemblies for supplying voltage and capacity. The battery cell assembly may include a plurality of battery cells connected in series, parallel, or combination by busbar components.

In some embodiments, a battery cell assembly is generally formed by the arrangement of a plurality of batteries.

As an example, the battery cell assembly may be a battery module, in which a plurality of batteries are arranged and fixed to form an independent module. As an example, the battery module may be formed by engaging a plurality of battery cells with a mounting plate having a slot by snap-fit.

In some embodiments, the battery device may be a battery pack including a case and one or more battery cell assemblies, and the battery cell assemblies are accommodated in the case.

As an example, the battery cell assembly may be a battery module, and the battery cell assembly may be accommodated in the case by fixing the battery module in the case.

As an example, the battery cell assembly may also be accommodated in the case by directly fixing the plurality of battery cells to the case.

The battery cell may be a lithium-ion battery, a sodium-ion battery, a sodium-lithium-ion battery, a lithium metal battery, a sodium metal battery, a lithium-sulfur battery, a magnesium-ion battery, a nickel-hydrogen battery, a nickel-cadmium battery, a lead storage battery, and the like, which is not limited in the embodiments of the present application.

The technical solutions described in the embodiments of the present application are applicable to various electric device that use battery cells, such as mobile phones, portable devices, laptops, battery cars, electric toys, electric tools, electric vehicles, ships, and spacecrafts. For example, the spacecraft includes an airplane, a rocket, a space shuttle, and a spaceship.

For the convenience of description, an embodiment of the present application in which a vehicle 1000 is taken as the example of the electric device is used for description.

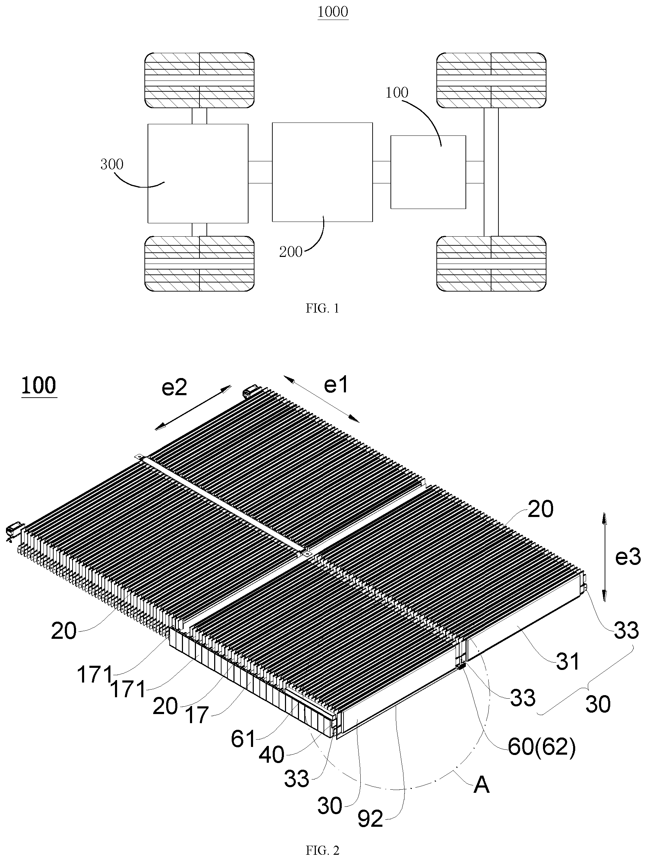

As shown in FIG. 1, FIG. 1 is a structural schematic view of a vehicle 1000 according to some embodiments of the present application. The vehicle 1000 may be a fuel vehicle, a gas vehicle or a new energy vehicle. The new energy vehicle may be a pure electric vehicle, a hybrid vehicle, an extended-range vehicle, or the like. A battery device 100 is provided inside the vehicle 1000, and the battery device 100 may be provided at a bottom, a head, or a tail of the vehicle 1000. The battery device 100 may be configured for powering the vehicle 1000. For example, the battery device 100 may serve as an operation power source of the vehicle 1000. The vehicle 1000 may further include a controller 200 and a motor 300. The controller 200 is configured for controlling the battery device 100 to power the motor 300, e.g., for the operation power needed by the vehicle 1000 for start-up, navigation, and driving.

In some embodiments of the present application, the battery device 100 may not only serve as an operation power source for the vehicle 1000, but also as a driving power source for the vehicle 1000 to, instead of or in part instead of fuel or natural gas, provide driving power for the vehicle 1000.

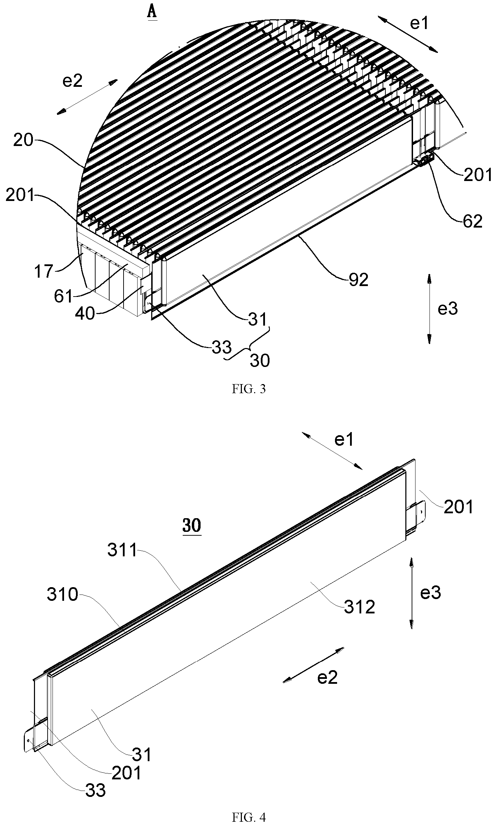

As shown in FIGs. 2 and 3, the battery device 100 includes a battery cell assembly 20 and a sampling assembly 80. The battery cell assembly 20 includes a plurality of battery cells 30 sequentially connected in series. The sampling assembly 80 includes a plurality of sampling parts, a plurality of connection wire harnesses 70, and an output port 921. Each sampling part is electrically connected to at least one connection wire harness 70, a plurality of the connection wire harnesses 70 are all connected to the output port 921. The plurality of sampling parts include a first sampling part 81 and a second sampling part 82. The first sampling part 81 and the second sampling part 82 are provided with a sampling point that can be electrically connected to the series path of the battery cells 30. The number of the first sampling parts 81 is two, and the two first sampling parts 81 are separately and electrically connected to the battery cell 30 at the front and the battery cell 30 at the rear of a plurality of the battery cells 30 sequentially connected in series. In the series path of a plurality of the battery cells 30, the number of the battery cells 30 between the sampling points of at least two adjacent second sampling parts 82 is greater than or equal to two.

The battery cell 30 includes a housing 31, an electrode assembly (not shown), and an electrolytic solution (not shown). The housing 31 is configured for accommodating the electrode assembly and the electrolytic solution, and the housing 31 may be flat, rectangular, cylindrical, or in other shapes, which is not limited in the embodiment of the present application.

The electrode assembly consists of a positive electrode plate (not shown), a negative electrode plate (not shown), and a separation film (not shown), and mainly operates through the movement of metal ions between the positive and negative electrode plates. The positive electrode plate includes a positive electrode current collector and a positive electrode active substance layer. The positive electrode active substance layer is applied to the surface of the positive electrode current collector. The positive electrode current collector not coated with the positive electrode active substance layer protrudes from the positive electrode current collector coated with the positive electrode active substance layer. The positive electrode current collector not coated with the positive electrode active substance layer serves as a positive electrode tab. Taking lithium-ion batteries as an example, the material of the positive electrode current collector may be aluminum, and the positive electrode active substance may be lithium cobaltate, lithium iron phosphate, ternary lithium, or lithium manganate, etc. The negative electrode plate includes a negative electrode current collector and a negative electrode active substance layer. The negative electrode active substance layer is applied to the surface of the negative electrode current collector. The negative electrode current collector not coated with the negative electrode active substance layer protrudes from the negative electrode current collector coated with the negative electrode active substance layer. The negative electrode current collector not coated with the negative electrode active substance layer serves as a negative electrode tab. The material of the negative electrode current collector may be copper, and the negative electrode active material may be carbon or silicon. To ensure the passing of a large current without fusing, there are a plurality of positive electrode tabs that are stacked together, and there are a plurality of negative electrode tabs that are stacked together.

The material of the separation film may be polypropylene (PP), polyethylene (PE), or the like. In addition, the electrode assembly may be a winding structure or a stacking structure, but the embodiments of the present application are not limited thereto.

The sampling assembly 80 is configured for acquiring parameters of the battery cell 30, where the parameters of the battery cell 30 include, but are not limited to, current, voltage, temperature, and the like. In the plurality of battery cells 30 sequentially connected in series, the battery cell 30 at the front is the first battery cell 30 in the battery cell assembly 20, and the battery cell 30 at the rear is the last battery cell 30 in the battery cell assembly 20. The sampling point may be a connection point of the sampling part and the battery cell 30. The sampling point may be located on one of the positive electrode tab or the negative electrode tab of the battery cell 30.

The sampling assembly 80 may acquire the parameters of the battery cell 30 between the sampling points of two sampling parts. Therefore, the two first sampling parts 81 are separately and electrically connected to the battery cell 30 at the front and the battery cell 30 at the rear in the series path of a plurality of the battery cells 30, and the first sampling parts 81 may acquire parameters of the plurality of battery cells 30 sequentially connected in series. Two adjacent second sampling parts 82 may acquire the number of all the battery cells 30 between the sampling points of the two second sampling parts 82.

The number of the plurality of battery cells 30 may be two or more. That is, the number of the sampling parts is at least two, and the sampling parts are separately and electrically connected to the front and rear ends of the two battery cells 30 connected in series.

In the series path of a plurality of the battery cells 30, the two adjacent sampling parts may be two first sampling parts 81, two second sampling parts 82, or one first sampling part 81 and one second sampling part 82. The number of the battery cells 30 between the sampling points of the two adjacent second sampling parts 82 may be one, two, three, or more, and the number of the battery cells 30 between the sampling points of at least two adjacent second sampling parts 82 is greater than or equal to two.

In the series path of the plurality of battery cells 30, that the number of the battery cells 30 between the sampling points of at least two adjacent second sampling parts 82 is greater than or equal to two, means that the circumstance where the number of the battery cells 30 between the sampling points of two adjacent second sampling parts 82 is greater than or equal to two may be present in a number of one, two, three, or more. The number of the battery cells 30 between every two adjacent second sampling parts 82 may be identical or different.

The number of the battery cells 30 between sampling points of two adjacent second sampling parts 82 may be less than or equal to the total number of the battery cells 30.

In the above technical solution, the sampling points of the two adjacent second sampling parts 82 in the series path of a plurality of the battery cells 30 may acquire parameters of the battery cells 30 between the two sampling points. There are at least two adjacent second sampling parts 82 in the battery device that can acquire parameters of two or more battery cells 30, such that the number of the sampling parts may be correspondingly reduced, and thus the wire harness connected to the sampling parts may also be shortened and simplified, thereby saving the mounting space, and improving the energy density of the battery device and the cost-efficiency to a certain extent.

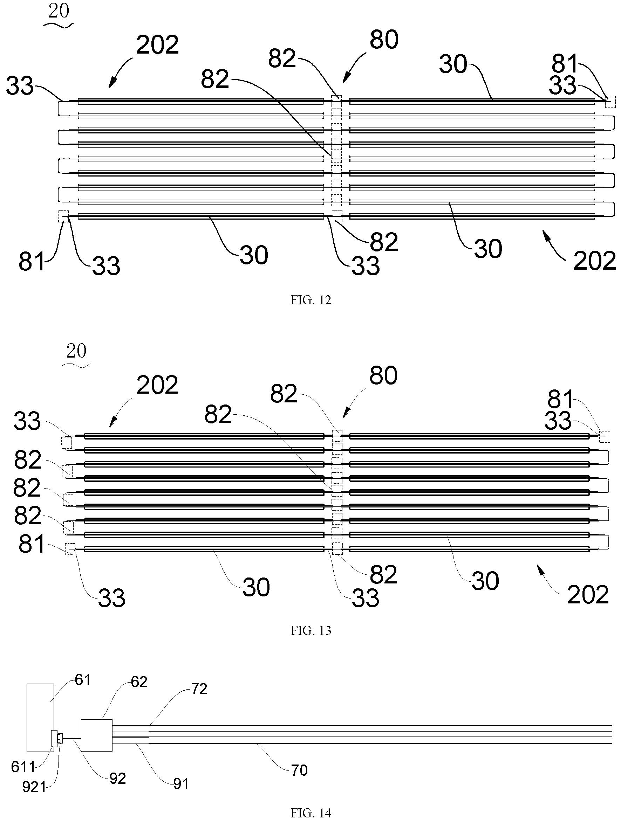

As shown in FIG. 12, according to some embodiments of the present application, optionally, in the series path of a plurality of the battery cells 30, the number of the battery cells 30 between the sampling points of every two adjacent second sampling parts 82 is equal, and is greater than or equal to two.

Specifically, the number of the battery cells 30 between the sampling points of every two adjacent second sampling parts 82 may be two, three, four, or more. In the embodiment shown in FIG. 12, the number of the battery cells 30 between the sampling points of every two adjacent second sampling parts 82 is two.

In the above technical solution, in the series path of a plurality of the battery cells 30, two battery cells 30 are provided between the sampling points of every two adjacent second sampling parts 82. Compared with the case that the sampling parts are separately arranged at both ends of each battery cell 30, the number of the sampling parts is reduced, and the sampling parts may be connected to the battery monitoring unit 61 by using shortened wire harnesses, thus saving the mounting space and improving the cost-efficiency to a certain extent.

As shown in FIGs. 12 and 13, according to some embodiments of the present application, optionally, in the series path of a plurality of the battery cells 30, one or more of the battery cells 30 are provided between the sampling point of the first sampling part 81 and the sampling point of the adjacent second sampling part 82.

Illustratively, as shown in FIGs. 12 and 13, in the series path of a plurality of the battery cells 30, one first sampling part 81 is electrically connected to the battery cell 30 at the front, and the sampling point of the second sampling part 82 adjacent to the first sampling part 81 is located between the battery cell 30 at the front and the next battery cell 30, such that one battery cell 30 is provided between the sampling points of the first sampling part 81 and the adjacent second sampling part 82, and the first sampling part 81 and the adjacent second sampling part 82 can separately acquire the parameters of the battery cell 30 at the front. In this embodiment, another first sampling part 81 is electrically connected to the battery cell 30 at the rear, and only the battery cell 30 at the rear may be provided between the sampling point of the second sampling part 82 adjacent to the first sampling part 81 and the sampling point of the first sampling part 81, such that the sampling assembly 80 can separately acquire the parameters of the battery cell 30 at the rear.

For another example, two or more battery cells 30 are provided between the first sampling part 81 electrically connected to the battery cell 30 at the front and the adjacent second sampling part 82.

For another example, two or more battery cells 30 are provided between the first sampling part 81 electrically connected to the battery cell 30 at the rear and the adjacent second sampling part 82.

In the above technical solution, in the series path of a plurality of the battery cells 30, the number of the battery cells 30 between the sampling points of the adjacent second sampling parts 82 may be one or more, thereby saving space and improving the sampling precision. The distribution positions of the sampling points may be flexibly adaptive to various arrangements of the battery cells 30.

As shown in FIGs. 12 and 13, according to some embodiments of the present application, optionally, a plurality of the battery cells 30 are arranged in a first direction to form a battery row 202; the battery cell assembly 20 includes at least one battery row 202; the sampling points of the two first sampling parts 81 are separately located on two sides of the battery cell assembly 20 in a second direction; the sampling points of the second sampling parts 82 are distributed on the same side or different sides of the battery row 202 in the second direction; the second direction and the first direction form an included angle.

The first direction may be referred to as the e1 direction in the drawings, and the second direction may be referred to as the e2 direction in the drawings. The first direction e1 may refer to one of the length direction, the width direction, and the thickness direction of the housing 31. Illustratively, as shown in FIG. 3, the first direction e1 may refer to the thickness direction of the housing 31, the second direction e2 refers to the length direction of the housing 31, and the first direction e1 and the second direction e2 may be perpendicular to each other.

Illustratively, as shown in FIGs. 12 and 13, the battery cell assembly 20 includes two battery rows 202, and the two battery rows 202 are arranged in the second direction. Two battery cells 30 adjacent in the second direction are connected in series. The sampling points of the two first sampling parts 81 are located on two opposite sides of all the battery cells 30 in the battery cell assembly 20 in the second direction, and the end parts of the battery cells 30 to which the sampling points of the two first sampling parts 81 are connected have opposite polarities. Furthermore, the sampling points of the two first sampling parts 81 may be two ends with the greatest distance in the first direction.

As shown in FIG. 12, all the sampling points of the second sampling part 82 are distributed on the same side of one of the battery rows 202 in the second direction.

As shown in FIG. 13, the sampling points of the second sampling parts 82 are distributed on two sides of one of the battery rows 202 in the second direction and are located on one side of the other battery row 202 in the second direction.

The sampling points of the plurality of second sampling parts 82 located on the same side of the battery row 202 in the second direction may be distributed and spaced apart of each other in the first direction, thereby increasing the number of the battery cells 30 between two adjacent sampling points on the series path of a plurality of the battery cells 30.

In the above technical solution, the sampling points of the two first sampling parts 81 are separately located on the two sides of the battery cell assembly 20 in the second direction, and in the series path of a plurality of the battery cells 30, the number of the battery cells 30 between the sampling points of the adjacent second sampling parts 82 may be one or more, thereby saving space, ensuring the parameter acquisition of all the battery cells 30, and improving the sampling precision to a certain extent.

According to some embodiments of the present application, optionally, a plurality of battery rows 202 are present, a plurality of the battery rows 202 are arranged in the second direction and/or a third direction, and the sampling points of the second sampling parts 82 are distributed at least on one side of one of the battery rows 202 in the arrangement direction thereof; every two of the first direction, the second direction, and the third direction form an included angle.

Specifically, the number of the battery rows 202 may be two or more, and the plurality of battery rows 202 may be arranged in the second direction. The plurality of battery rows 202 arranged in the second direction may be connected in series by sequentially connecting the adjacent battery cells 30 in series in the second direction; or alternatively, the adjacent battery cells 30 in the first direction in every battery row 202 are sequentially connected in series, and one battery row 202 is connected to another in series at the front or rear in the first direction. The plurality of the battery rows 202 may also be arranged in the third direction, or arranged in a three-dimensional array in the second direction and the third direction.

In this embodiment, the two first sampling parts 81 are electrically connected to the two battery cells 30 at the front and the rear in the series path of all the battery cells 30, so as to ensure that all the battery cells 30 can be sampled.

Illustratively, the plurality of battery rows 202 are arranged in the second direction and may be connected in series by sequentially connecting the adjacent battery cells 30 in series in the second direction. The sampling points of the second sampling parts 82 may be distributed on one side of one of the battery row 202 of the plurality of battery rows 202 in the second direction. In this embodiment, the sampling points of two adjacent second sampling parts 82 in the first direction may acquire the parameters of all the battery cells 30 located in the same row in the second direction, thus greatly reducing the number of the sampling parts.

In the above technical solution, the sampling points of the second sampling parts 82 are at least distributed on one side of one of the battery rows 202 in its arrangement direction, thereby saving the mounting space of the sampling assembly 80. The distribution positions of the sampling points may be flexibly adaptive to various arrangements of the battery cells 30.

As shown in FIG. 12, according to some embodiments of the present application, optionally, the number of the battery rows 202 is two, and the two battery rows 202 are arranged in the second direction; the sampling points of the second sampling parts 82 are distributed between the two battery rows 202.

Specifically, two battery cells 30 arranged in parallel in the second direction in the two battery rows 202 are connected in series, and the sampling points of the second sampling parts 82 are distributed between the two battery rows 202. One battery cell 30 is provided between the sampling points of each of the first sampling part 81 and the adjacent second sampling part 82, and the two battery cells 30 located between the sampling points of the first sampling part 81 and the second sampling part 82 are the battery cell 30 at the front and the battery cell 30 at the rear in the battery cell assembly 20. The sampling points of the second sampling parts 82 are located between the two battery rows 202, such that in the series path of a plurality of the battery cells 30, two battery cells 30 are provided between the sampling points of every two adjacent second sampling parts 82.

In this embodiment, the first sampling part 81 and the adjacent second sampling part 82 can separately acquire the parameters of the two battery cells 30 at the front and the rear, and every two adjacent second sampling parts 82 in the series path of a plurality of the battery cells 30 acquire the parameters of two battery cells 30 between the two second sampling parts 82.

In the above technical solution, the sampling points of the second sampling parts 82 are distributed between two adjacent battery rows 202 to concentrate the positions of the second sampling parts 82 and help save the mounting space of the sampling assembly 80, thus facilitating the wiring and assembly.

As shown in FIG. 13, according to some embodiments of the present application, optionally, the number of the battery rows 202 is two, and the two battery rows 202 are arranged in the second direction; the sampling points of the second sampling parts 82 are distributed on the two sides of one of the battery rows 202 in the second direction.

Specifically, the two battery rows 202 are a first battery row 202 and a second battery row 202. The sampling points of the second sampling parts 82 are distributed on both sides of the first battery row 202 in the second direction, and the second sampling points are distributed only on the side of the second battery row 202 proximal to the first battery row 202. In this embodiment, the output port 921 may be disposed close to the side of the first battery row 202 in the second direction to simplify the wiring and shorten the total length of the connection wire harnesses 70.

Furthermore, the two sides of each battery cell 30 in the first battery row 202 may be provided with one sampling point of the second sampling part 82, so as to acquire the parameters of each battery cell 30 in the first battery row 202, thus improving the sampling precision. In the second battery row 202, the second sampling parts 82 sample two adjacent battery cells 30 in pairs in the series path.

In some other embodiments, the sampling points located on the same side of the first battery row 202 may be spaced by two or more battery cells 30. Since the sampling points on the two sides of the first battery row 202 are distributed more densely than the sampling points on the two sides of the second battery row 202, the sampling precision of the first battery row 202 can be improved, and the total number of the sampling parts may be reduced.

In the above technical solution, the sampling points of the second sampling parts 82 are distributed on the two sides of one of the battery rows 202 in the second direction, and each battery cell 30 in the battery row 202 can be sampled individually, thus locally improving the sampling precision and facilitating the battery management system to accurately adjust the battery management strategy according to the sampling parameters.

Referring to FIG. 12, according to some embodiments of the present application, optionally, a plurality of the battery cells 30 are arranged in the first direction to form the battery row 202; the number of the battery rows 202 is at least two, and at least two of the battery rows 202 are arranged in the second direction; the battery monitoring unit 61 is disposed on one side of all the battery rows 202 or between two adjacent battery rows 202 in the second direction; the first direction and the second direction are disposed with an included angle.

In the above technical solution, a plurality of the battery cells 30 are arranged in the first direction to form the battery row 202, and the number of the battery rows 202 is at least two, such that the overall output voltage of the battery device can be increased. In the second direction, the battery monitoring unit 61 is disposed between two battery cell assemblies 20 or on one side of all battery cell assemblies 20 to make the structure compact, thus saving the space in the second direction.

According to some embodiments of the present application, optionally, the battery cell 30 includes a housing 31 and conductive parts 33; the conductive parts 33 are provided at end parts of the housing 31 in the second direction, and the conductive parts 33 of two adjacent battery cells 30 in the second direction are connected; the first end part 71 of the connection wire harness 70 is connected to a part of the conductive parts 33 to form the sampling part.

In the above technical solution, the connection between the conductive parts 33 of two adjacent battery cells 30 arranged in the second direction can omit or reduce the electrical connection member between the battery cells 30, thus reducing the number of parts in the battery cell assembly 20, saving the space occupied by the electrical connection members, and helping improve the energy density of the battery cell assembly 20. The conductive parts 33 are connected to the first end part 71 of the connection wire harness 70 to form the sampling part, thus simplifying the structure of the sampling part.

According to some embodiments of the present application, optionally, the battery cell assembly 20 includes a plurality of battery cells 30 arranged in a first direction, each battery cell 30 includes a housing 31 and conductive parts 33, and the conductive parts 33 are provided at end parts of the housing 31 in the second direction; all the conductive parts 33 located on the same side of a plurality of the battery cells 30 of the battery cell assembly 20 are sequentially arranged in the first direction; in the third direction, a plurality of the conductive parts 33 and the end part of the battery cell assembly 20 form an accommodating gap 201; the battery monitoring unit 61 is disposed in the accommodating gap 201 and electrically connected to the conductive parts 33; every two of the first direction, the second direction, and the third direction are disposed with an included angle.

The first direction may be referred to as the e1 direction in the drawings, the second direction may be referred to as the e2 direction in the drawings, and the third direction may be referred to as the e3 direction in the drawings. In some embodiments of the present application, the first direction, the second direction, and the third direction may be perpendicular to each other.

The conductive part 33 is electrically connected to the electrode assembly and is at least partially exposed outside the housing 31. In the present application, the battery cell 30 may be a battery cell using a soft outer package material as the housing 31. The housing 31 is a flexible structure. For example, the housing 31 may be made of an aluminum-plastic film.

The conductive part 33 of the battery cell 30 is connected to a tab, and at least a part of the conductive part 33 is located outside the housing 31 to serve as a lead-out structure of the electrode assembly, and the conductive part 33 may be configured for electrically connecting the battery cell 30 to other battery cells 30 or other components.

Since the outer housing 31 is of a flexible structure, the battery cell 30 is difficult to maintain a stable and fixed outer contour. The outer contour of the housing 31 may have approximately a flat rectangular shape, and the battery cells 30 may be arranged in an orientation in which the thickness direction, the length direction, and the width direction of the housing 31 correspond to the first direction, the second direction, and the third direction, respectively. The plurality of battery cells 30 are arranged sequentially in the thickness direction thereof. That is, the dimension of the outer contour of the housing 31 in the second direction (the length of the housing 31) may be significantly greater than the dimensions in the first direction and the third direction (the width and the thickness), and the dimension of the outer contour of the housing 31 in the third direction (the width) is also greater than the dimension in the first direction (the thickness).

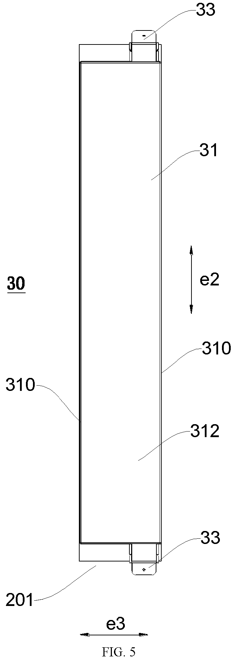

As shown in FIGs. 3-5, the conductive parts 33 may be provided at both end parts of the battery cell 30 in the second direction. The conductive part 33 may at least partially protrude from the end part of the housing 31 in the second direction. The interval spacing, in the third direction, the portions of the plurality of conductive parts 33 protruding from the housing 31 apart from one end part of the battery cell assembly 20 in the third direction to form the accommodating gap 201. In the third direction, the distance between the conductive part 33 and the end part of the battery cell assembly 20, or the width of the accommodating gap 201, is greater than or equal to the dimension of the battery monitoring unit 61 in the third direction.

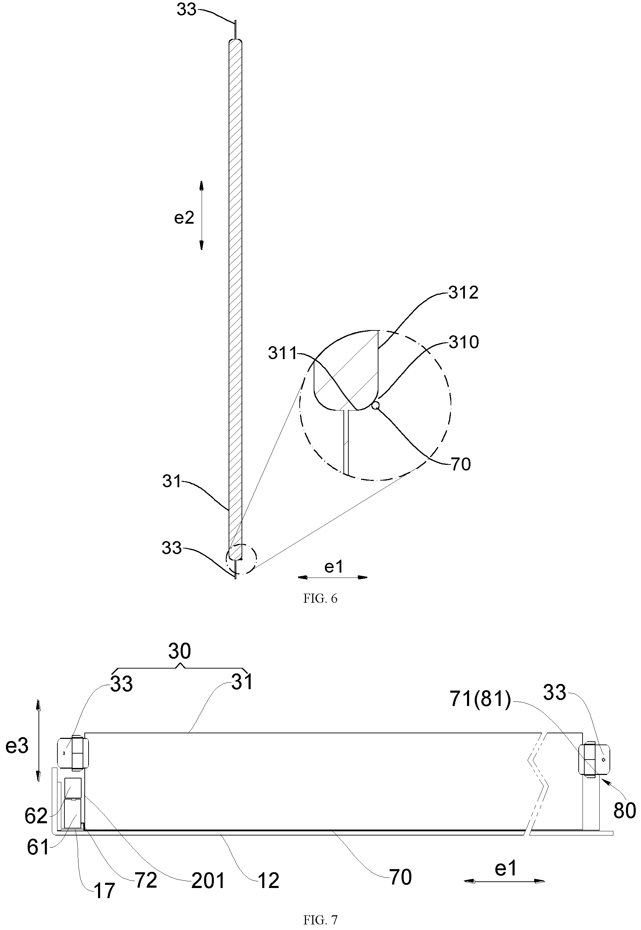

Optionally, as shown in FIG. 7, the distance by which the conductive part 33 protrudes from the end part of the housing 31 in the second direction is greater than or equal to the dimension of the battery monitoring unit 61 in the second direction.

As will be readily appreciated, the conductive part 33 at least partially protrudes from the end part of the housing 31, such that the space occupied by the battery cell 30 in the battery device 100 is further expanded outward on the basis of the volume of the housing 31, and the accommodating gap 201 formed between the conductive part 33 and the end part of the battery cell 30 in the third direction is contained in the space occupied by the battery cell 30. Compared with the techniques that the battery monitoring unit 61 is disposed outside the space occupied by the battery cell 30, the battery monitoring unit 61 in the embodiment of the present application is disposed in the accommodating gap 201. That is, the battery monitoring unit 61 is mounted in the space occupied by the battery cell 30, thereby making the structure more compact, and improving the space utilization and thus the capacity density of the battery device 100.

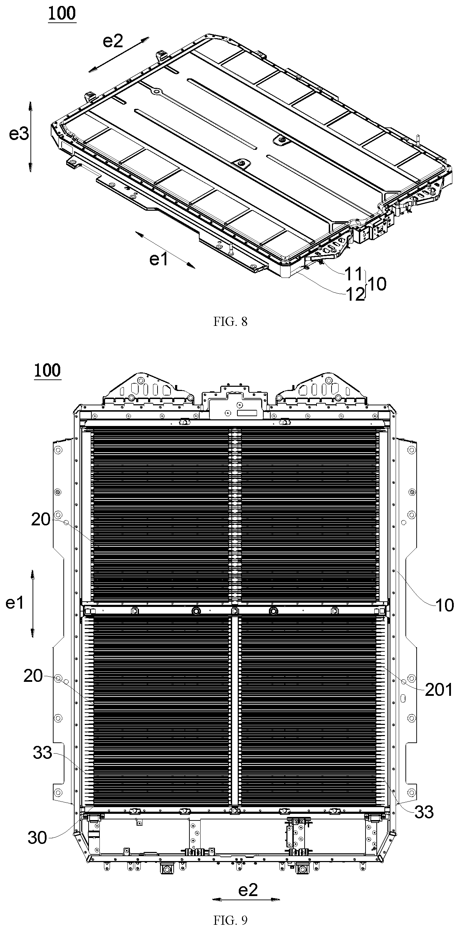

Optionally, as shown in FIG. 9, in the same battery cell assembly 20, all the conductive parts 33 located on the same side may be sequentially arranged in the first direction and flush in the third direction. That is, in the third direction, the portions of the plurality of conductive parts 33 protruding from the housing 31 are spaced apart from the end part of the battery cell assembly 20 in the third direction by the same distance.

The battery monitoring unit 61 may be directly connected to the conductive part 33, or may be indirectly connected to the conductive part 33 through a connection wire harness 70 such as a wire or a connector. Each of the battery cells 30 in the battery device 100 may be electrically connected to the battery monitoring unit 61.

In the battery device 100 according to the embodiments of the present application, the plurality of battery cells 30 of the battery cell assembly 20 are arranged in the first direction, and the end part of the battery cell 30 in the second direction is provided with the conductive part 33. All the conductive parts 33 located on the same side of a plurality of the battery cells 30 are sequentially arranged in the first direction, and all the conductive parts 33 located on the side form an accommodating gap 201 with the end part of the battery cell assembly 20 in the third direction. The battery monitoring unit 61 is disposed in the accommodating gap 201 and connected to the conductive part 33, such that the battery monitoring unit 61 can utilize the accommodating gap 201 as the mounting space, making the structure of the battery device 100 more compact, saving space, and further helping improve the energy density of the battery device 100.

The battery monitoring unit 61 is configured to collect the parameters such as voltage, current, temperature, and the like of one or more battery cells 30. Correspondingly, the battery monitoring unit 61 may include a detection unit such as a voltage sensor, a current sensor, and/or a temperature sensor. The battery monitoring unit 61 further includes a slave controller 200 (or cell supervision circuit, CSC) and is configured to transmit parameters of the battery cells 30 to a master control board (or battery management unit, BMU).

As shown in FIG. 3, in one specific embodiment, the battery device 100 includes the battery monitoring unit 61 and an electrical connection member 62. The battery monitoring unit 61 is disposed in the accommodating gap 201 formed by the conductive parts 33 on the two sides of the battery cell 30 in the second direction. In this embodiment, the battery device 100 includes a second patch cable 92. One end of the second patch cable 92 is connected to the battery monitoring unit 61, and the other end is connected to the electrical connection member 62, so as to achieve the electrical connection between the battery monitoring unit 61 and the electrical connection member 62.

In this embodiment, optionally, the battery monitoring unit 61 and the electrical connection member 62 are respectively located in the accommodating gaps 201 formed on the upper and lower sides of the conductive part 33 in the third direction.

As shown in FIG. 7, the battery device 100 includes the battery monitoring unit 61 and the electrical connection member 62. The battery monitoring unit 61 and the electrical connection member 62 are connected together and collectively accommodated in the accommodating gap 201. The battery cell 30 is electrically connected to the electrical connection member 62 and is electrically connected to the battery monitoring unit 61 through the electrical connection member 62, such that the battery monitoring unit 61 can receive the parameters of the battery cell 30.

In this embodiment, optionally, the electrical connection member 62 is connected to the battery control unit by means of plug-in, thereby improving the connection reliability and saving the mounting space.

In the above technical solution, the battery device 100 includes the battery monitoring unit 61 and/or the electrical connection member 62. One of the battery monitoring unit 61 and the electrical connection member 62 is electrically connected to the conductive part 33, such that the battery monitoring unit 61 and/or the electrical connection member 62 can be electrically connected to the battery cell 30 through the conductive part 33, and thus the battery management system can monitor and regulate the battery cell assembly 20 through the battery monitoring unit 61. In addition, the battery monitoring unit 61 may further acquire the parameters of the battery cells 30 for reference by the battery management system for the management strategy.

As shown in FIG. 7, according to some embodiments of the present application, optionally, the battery device 100 includes the battery monitoring unit 61 and the electrical connection member 62. The electrical connection member 62 is located between the conductive part 33 and the battery monitoring unit 61 and electrically connected to the battery monitoring unit 61 and the conductive part 33.

Specifically, the electrical connection member 62 and the battery monitoring unit 61 are collectively accommodated in the accommodating gap 201. The plurality of conductive parts 33, the electrical connection members 62, and the battery monitoring unit 61 that are located on the same side may be stacked in the third direction. The electrical connection member 62 may be connected to the plurality of conductive parts 33 through a connection wire harness 70, or may be directly connected to a part of the plurality of conductive parts 33. The electrical connection member 62 may be connected to the battery monitoring unit 61 through an electrical connection terminal, a wire harness, or an electrical connection part forming a mortise and tenon structure.

In the above technical solution, the electrical connection member 62 is located between the conductive part 33 and the battery monitoring unit 61 and connected to the conductive part 33 and the battery monitoring unit 61, such that the conductive parts 33 of the plurality of battery cells 30 can be connected to the battery monitoring unit 61 through the electrical connection member 62, thus further utilizing the space of the accommodating gap 201 in the third direction, making the structure more compact, and saving the mounting space required by the battery monitoring unit 61 while achieving the electrical connection between the battery monitoring unit 61 and the plurality of battery cells 30.

According to some embodiments of the present application, optionally, the battery device 100 includes a master control board (not shown), and the battery monitoring unit 61 is electrically connected to the master control board.

Specifically, the master control board may be integrated with various structures with control functionality and electronic components in the battery management system. The battery monitoring unit 61 is electrically connected to the conductive part 33 to collect parameters such as current, voltage, temperature, and the like of the battery cell 30. The battery monitoring unit 61 may include the slave controller 200, and may be connected to the master control board through a communication wire harness, so as to transmit the parameters of the battery cells 30 to the master control board.

In the above technical solution, the battery device 100 includes a master control board, and the battery monitoring unit 61 includes the battery monitoring unit 61. The battery monitoring unit 61 is electrically connected to the master control board and can acquire the parameters of the battery cell 30, such that the master control board can accurately and reliably acquire parameters of the battery cell 30, and timely adjust the control strategy for the battery device 100 according to the state of the battery cell 30.

Referring to FIGs. 7-10, according to some embodiments of the present application, optionally, the battery device 100 includes a case 10 including a bottom plate 12, and the accommodating gap 201 is located between the bottom plate 12 and the conductive part 33.

Specifically, the case 10 is provided with an accommodating space 10a, and the battery cell assembly 20 is disposed in the accommodating space 10a. The accommodating space 10a may refer to a space defined inside the case 10 for accommodating the battery cell assembly 20 and other devices. The shape of the case 10 may be, but is not limited to, rectangular, cubic, cylindrical, and the like. The material of the case 10 may be, but is not limited to, a metal material or a non-metal material. The metal material may include, but is not limited to, aluminum alloy, stainless steel, etc., and the non-metal material may include, but is not limited to, plastic, a carbon fiber composite material, etc.

As an example, the case 10 may include a first case and a second case. The first case and the second case are fastened together, so as to form an enclosed space inside the case 10 to accommodate the battery cell assembly 20. The term "enclosed" as used herein refers to covering or closing, either sealed or unsealed. The first case may be a top cover 11 or a bottom plate 12.

As an example, the case 10 may include a top cover 11, a frame, and a bottom plate 12. The top cover 11 and the bottom plate 12 are separately connected to the frame, so as to form the enclosed space inside the case 10 to accommodate the battery cell assembly 20.

In some embodiments, the case 10 may be a part of the chassis structure of the vehicle 1000. For example, a portion of the case 10 may be at least a portion of the floor of the vehicle 1000, or a portion of the case 10 may be at least a portion of a transverse beam and a longitudinal beam of the vehicle 1000.

Optionally, the top cover 11 and the bottom plate 12 are opposite to each other in the third direction, and the battery cell assembly 20 is located in a region where the top cover 11 and the bottom plate 12 are opposite to each other. One end part of the battery cell assembly 20 in the third direction abuts against the top cover 11 or is disposed close to the top cover 11, and the other end part of the battery cell assembly 20 in the third direction abuts against the bottom plate 12. The conductive part 33 and the end part of the battery cell assembly 20 in the third direction abutting against the bottom plate 12 form the accommodating gap 201. The conductive part 33 protrudes from the end part of the housing 31 in the second direction, and the conductive part 33 and the bottom plate 12 are opposite and spaced apart from each other in the third direction and collectively define the boundary range of the accommodating gap 201. In this embodiment, the battery cell assembly 20 may be fixedly connected to the bottom plate 12.

Furthermore, in the third direction, the conductive part 33 is disposed close to the top cover 11, that is, the distance between the conductive part 33 and the end part of the battery cell assembly 20 close to the top cover 11 is less than the distance between the conductive part 33 and the end part of the battery cell assembly 20 close to the bottom plate 12, so as to increase the spatial range of the accommodating gap 201.

In the above technical solution, the battery cell assembly 20 is accommodated in the battery device 100 through the case 10, the case 10 can provide support and protection for the battery cell 30, and the accommodating gap 201 is located between the bottom plate 12 of the case 10 and the conductive part 33, such that the boundary range of the accommodating gap 201 in the third direction is clear, and the bottom plate 12 can provide support for the battery monitoring unit 61 in the accommodating gap 201, making the battery monitoring unit 61 mounted more stably in the accommodating gap 201.

As shown in FIGs. 3 and 7, according to some embodiments of the present application, optionally, the battery device 100 includes a support 17 connected to the case 10, and the battery monitoring unit 61 is mounted to the support 17.

Specifically, the support 17 is located on at least one side of the battery cell assembly 20 in the second direction. The support 17 may be located on one side of the battery cell assembly 20 in the second direction, or the support 17 may be located on both sides of the battery cell assembly 20 in the second direction. The battery monitoring unit 61 may be connected to the support 17 by at least one connection manner such as welding, screwing, riveting, snap-fit, adhesion, fasteners, and the like. The battery monitoring unit 61 and the support 17 may be fixedly connected in a detachable manner.

Optionally, the support 17 includes a plurality of sub-supports 171. The plurality of sub-supports 171 of the support 17 may be arranged in the first direction, and two adjacent sub-supports 171 may be connected. The plurality of sub-supports 171 may be formed independently. For example, two adjacent sub-supports 171 may be connected by welding or by a structural adhesive or by fasteners; alternatively, the plurality of sub-supports 171 may be integrally formed.

Two adjacent sub-supports 171 may form a through mounting space in the extending direction (e.g., the first direction) of the battery monitoring unit 61 to accommodate the battery monitoring unit 61.

In the above technical solution, the support 17 is connected to the case 10, and the battery monitoring unit 61 is mounted to the support 17, such that the battery monitoring unit 61 can be connected to the case 10 through the support 17, thus improving the mounting stability and reliability of the battery monitoring unit 61 and helping improve the integral rigidity and strength of the battery device 100.

According to some embodiments of the present application, optionally, the battery monitoring unit 61 is bonded to a case wall 111 of the case 10.

Specifically, the case wall 111 of the case 10 surrounds the accommodating space 10a, and the case wall 111 may be a wall surface of the case 10 on any side in the first direction, the second direction, or the third direction. The battery monitoring unit 61 is disposed in the accommodating gap 201 with the surface on at least one side facing the case 10. The surface of the battery monitoring unit 61 facing the case 10 may be bonded to the inner wall surface of the case 10.

Illustratively, the conductive part 33, the end part of the housing 31 in the second direction, and the bottom plate 12 collectively form the accommodating gap 201. The battery monitoring unit 61 is accommodated in the accommodating gap 201, and the battery monitoring unit 61 is located between the conductive part 33 and the bottom plate 12 in the third direction and between the side case wall of the case 10 and the housing 31 in the second direction. The battery monitoring unit 61 may be directly connected to the bottom plate 12, and/or the battery monitoring unit 61 may be directly connected to the case wall 111 of the case 10 opposite in the second direction.

The battery monitoring unit 61 may be connected to the case wall 111 of the case 10 by a structural adhesive, an adhesive, an adhesive film, or the like.

In the above technical solution, the battery monitoring unit 61 is bonded to the case wall 111 of the case 10, such that the battery monitoring unit 61 is integrally connected to the case wall 111 of the case 10, thus facilitating the integration of the battery monitoring unit 61 with the case 10, saving the occupied space, helping with the assembly of parts in the battery device 100, and facilitating the insulation, isolation and protection between the battery monitoring unit 61 and the case 10.

As shown in FIG. 2, according to some embodiments of the present application, optionally, the length of the battery monitoring unit 61 extends in the first direction.

Specifically, as shown in FIG. 7, the accommodating gap 201 is formed in the space between the conductive part 33 and the bottom plate 12 in the third direction, and the plurality of conductive parts 33 located on the same side are sequentially arranged in the first direction, such that the accommodating gap 201 formed by the conductive parts 33 on the same side extends in the first direction. The battery monitoring unit 61 is disposed in the accommodating space 10a and extends in the extending direction of the accommodating gap 201, i.e., in the first direction. The outer contour of the battery monitoring unit 61 may be an elongate plate or an elongate bar.

In the above technical solution, the length of the battery monitoring unit 61 extends in the first direction, and the accommodating gap 201 also extends in the first direction, such that the space where the accommodating gap 201 is located can be fully filled with the battery monitoring unit 61, thus improving the space utilization.

As shown in FIGs. 2 and 9, according to some embodiments of the present application, optionally, a plurality of the battery cell assemblies 20 are present and arranged in the second direction, and the battery monitoring unit 61 is disposed between the two battery cell assemblies 20 or disposed on one side of all the battery cell assemblies 20.

Specifically, the plurality of battery cell assemblies 20 may be electrically connected to the battery monitoring unit 61. The number of the battery cells 30 may be two, three, or more. The plurality of battery cells 30 in each battery cell assembly 20 are arranged in the first direction, and the end parts of the battery cells 30 on the same side in the second direction may be flush with each other in the second direction.

Illustratively, the number of the battery cell assemblies 20 is two, and the battery monitoring unit 61 may be disposed on one of two opposite sides of the two battery cell assemblies 20 in the second direction.

Illustratively, the number of the battery cell assemblies 20 is two, the conductive parts 33 of the two battery cell assemblies 20 proximal to each other in the second direction form an accommodating gap 201 in the third direction, and the battery monitoring unit 61 is disposed in the accommodating gaps 201 of the battery cell assemblies 20 proximal to each other.

Illustratively, the number of the battery cell assemblies 20 is three, and the battery monitoring unit 61 may be disposed on the side of the first or last battery cell assembly 20 distal to the other battery cell assemblies 20 in the second direction.

Illustratively, the number of the battery cell assemblies 20 is three, and the battery monitoring unit 61 is disposed between two of the battery cell assemblies 20.

In the above technical solution, the presence of more than one battery cell assemblies 20 can increase the overall output voltage of the battery device 100. In the second direction, the battery monitoring unit 61 is disposed between two battery cell assemblies 20 or on one side of all battery cell assemblies 20 to make the structure compact, thus saving the space in the second direction.

As shown in FIGs. 3 and 7, according to some embodiments of the present application, optionally, the battery monitoring unit 61 includes the battery monitoring unit 61, and the at least one conductive part 33 of each battery cell 30 is electrically connected to the battery monitoring unit 61 through the connection wire harness 70.

Specifically, two conductive parts 33 may be provided on each battery cell 30. One of the two conductive parts 33 is a positive electrode conductive part, and the other is a negative electrode conductive part. One of the two conductive parts 33 of the battery cell 30 is disposed on one side of the battery cell 30 in the second direction, and the other of the two conductive parts 33 of the battery cell 30 is disposed on the other side of the battery cell 30 in the second direction. The dimension of the battery cell 30 in the second direction may be significantly greater than the dimensions in the first direction and the second direction, that is, the length direction of the battery cell is parallel to the second direction; the two conductive parts 33 of the battery cell 30 are located on opposite sides in the length direction of the battery cell 30.

Illustratively, in the plurality of battery cells 30, one of the two conductive parts 33 of each battery cell 30 is connected to the connection wire harness 70, and is electrically connected to the battery monitoring unit 61 through the connection wire harness 70; the other of the two conductive parts 33 of the battery cell 30 is not electrically connected to the connection wire harness 70 and the battery monitoring unit 61.

Illustratively, in the plurality of battery cells 30, the two conductive parts 33 of each battery cell 30 are connected to the connection wire harness 70 and electrically connected to the battery monitoring unit 61 through the connection wire harness 70.

Illustratively, in the plurality of battery cells 30, the conductive parts 33 at both ends of a part of the battery cells 30 are connected to the connection wire harness 70 and electrically connected to the battery monitoring unit 61, and only one conductive part 33 of another part of the battery cells 30 is connected to the connection wire harness 70.

In the above technical solution, at least one conductive part 33 of each battery cell 30 is electrically connected to the battery monitoring unit 61 through the connection wire harness 70, such that an electrical connection is established between the battery monitoring unit 61 and each battery cell 30, thus allowing the battery monitoring unit 61 to monitor the state of each battery cell 30 and improving the precision of the monitoring and management by the battery management system.

As shown in FIGs. 4-6, according to some embodiments of the present application, optionally, a corner space 310 is formed at a corner of the housing 31 in the third direction; the connection wire harness 70 is at least partially located in the corner space 310 and extends in the second direction.

Specifically, the housing 31 includes a first surface 311 and a second surface 312 that are connected. The first surface 311 is parallel to a plane where the first direction and the second direction are located, and the second surface 312 is parallel to a plane where the second direction and the third direction are located. The connection of the first surface 311 and the second surface 312 is located at the end part of the second surface 312 in the third direction and forms an arc transition surface. The arc transition surface at the connection of the first surface 311 and the second surface 312 extends in the second direction, and the arc transition surface and the extension planes of the first surface 311 and the second surface 312 jointly define the corner space 310. The end parts of the connection wire harness 70 may be separately connected to the battery monitoring unit 61 and the conductive part 33, and the portion of the connection wire harness 70 between the conductive part 33 and the two end parts of the battery monitoring unit 61 extends in the second direction and is accommodated in the corner space 310.

Furthermore, the connection wire harness 70 may be attached to the outer wall surface of the housing 31 in the corner space 310.

In the above technical solution, a corner space 310 is formed at a corner of the housing 31 in the third direction, the connection wire harness 70 is at least partially located in the corner space 310 and extends in the second direction, and the corner of the housing 31 in the third direction also extends in the second direction, such that the connection wire harness 70 can extend in the corner space 310, thereby making full use of the volume space occupied by the battery cell 30 to accommodate the connection wire harness 70 and improving the space utilization.

As shown in FIGs. 3 and 7, according to some embodiments of the present application, optionally, the connection wire harness 70 includes a first end part 71 and a second end part 72 that are opposite; the first end part 71 is connected to the conductive part 33 by welding or bonding, and the second end part 72 is electrically connected to the battery monitoring unit 61.

Specifically, the first end part 71 and the second end part 72 are two end parts of the connection wire harness 70 that are opposite in the second direction. The first end part 71 may be welded to the portion of the conductive part 33 protruding from the housing 31, or may be bonded to the portion of the conductive part 33 protruding from the housing 31 by a conductive adhesive or an insulating tape. The second end part 72 may be connected to the battery monitoring unit 61 in direct contact, or may be indirectly connected to the battery monitoring unit 61 through the electrical connection member 62.

In the above technical solution, by welding or bonding the first end part 71 of the connection wire harness 70 to the conductive part 33, the stability of the connection between the first end part 71 of the connection wire harness 70 and the conductive part 33 can be increased. The second end part 72 is electrically connected to the battery monitoring unit 61, such that the first end part 71 of the connection wire harness 70 can sample the voltage of a connected battery cell 30 and transmit the voltage information acquired by sampling to the battery monitoring unit 61 through the second end part 72, thus ensuring the accuracy and stability of sampling. The connection wire harness 70 achieves the voltage sampling while achieving the electrical connection, and thus may save the number of parts and the mounting space.

According to some embodiments of the present application, optionally, the second end part 72 and the battery monitoring unit 61 are connected by welding.

In the above technical solution, the second end part 72 and the battery monitoring unit 61 are connected by welding, thus helping reduce the number of the adapting members and wire harnesses and saving the mounting space.

According to some embodiments of the present application, optionally, the second end part 72 is connected to the output port 921; the battery monitoring unit 61 is provided with a connector, and the output port 921 is connected to the connector by means of plug-in.

In the above technical solution, the second end part 72 is connected to the battery monitoring unit 61 through the output port 921 and the connector by means of plug-in, thereby improving the connection reliability of the connection wire harness 70 and the battery monitoring unit 61.

In some embodiments, the portion of the connection wire harness 70 between the first end part 71 and the second end part 72 may also be fixedly connected to the housing 31 by a fastener (not shown). A plurality of fasteners may be present, and the plurality of fasteners are provided and spaced apart from each other in the extending direction of the connection wire harness 70. The fasteners include, but are not limited to, adhesive tape, structural adhesive, cable ties, cable clips, and the like.

As shown in FIG. 14, according to some embodiments of the present application, optionally, the battery monitoring unit 61 includes the electrical connection member 62, and the battery device 100 includes a first patch cable 91, and a second patch cable 92. The first patch cable 91 and the second patch cable 92 are both connected to the electrical connection member 62. The second end parts 72 of a plurality of the connection wire harnesses 70 are connected to the electrical connection member 62 through the corresponding first patch cable 91, and the end of the second patch cable 92 distal to the electrical connection member 62 is connected to the battery monitoring unit 61.

It should be noted that FIG. 14 shows a modularized connection manner among the electrical connection member 62, the battery monitoring unit 61, and the connection wire harness 70 through the first patch cable 91 and the second patch cable 92. The positions and shapes of the components in the drawing do not indicate the actual positional relationship and the actual form. For example, the connection wire harness 70, the first patch cable 91, and the second patch cable 92 are flexible components, and are often disposed on the surface or in the gap of structures such as the battery cell 30, the battery monitoring unit 61, or the case 10 during the actual assembly process, so as to obtain structural support and fixed positions.

Specifically, a plurality of first patch cables 91 are present in one-to-one correspondence with the connection wire harnesses 70. The first end parts 71 of the plurality of connection wire harnesses 70 are separately welded or bonded to the conductive parts 33 of the plurality of battery cells 30, and the second end parts 72 of the plurality of connection wire harnesses 70 are correspondingly connected to the electrical connection member 62 through the first patch cable 91, such that the plurality of battery cells 30 are electrically connected to the electrical connection member 62. The electrical connection member 62 is connected to the battery monitoring unit 61 through the second patch cable 92, and the second patch cable 92 can gather information transmitted by all the second patch cables 92 connected to the electrical connection member 62, such that the plurality of battery cells 30 are electrically connected to the battery monitoring unit 61.

In the above technical solution, the second end parts 72 of the connection wire harnesses 70 are connected to the electrical connection member 62 through the corresponding first patch cable 91, and the end of the second patch cable 92 distal to the electrical connection member 62 is connected to the battery monitoring unit 61, such that the connection wire harnesses 70 are gathered before being connected to the battery monitoring unit 61, thus simplifying the electrical connecting lines between the connection wire harnesses 70 and the battery monitoring unit 61, saving the mounting space, and facilitating the recognition, assembly and maintenance.

As shown in FIG. 14, according to some embodiments of the present application, optionally, the end of the second patch cable 92 distal to the electrical connection member 62 is connected to the output port 921; the battery monitoring unit 61 is provided with a connector 611, and the output port 921 is connected to the connector 611 by means of plug-in.

Specifically, the output port 921 may be a plug, and the output port 921 forms a connection terminal protruding from an end surface of the output port 921. The connector 611 may be a socket, and the connector 611 is provided with a connection terminal recessed with respect to the surface of the connector 611. The connection terminal of the output port 921 is inserted into the connector 611 and is held in contact with the connection terminal of the connector 611, thus achieving the electrical connection of the second patch cable 92 and the battery monitoring unit 61.

For another example, the connection of the output port 921 to the connector 611 by means of plug-in may be that the connector 611 is partially inserted into the output port 921.

In the above technical solution, the end of the second patch cable 92 distal to the electrical connection member 62 is connected to the output port 921, the battery monitoring unit 61 is provided with a connector 611, and the output port 921 is connected to the connector 611 by means of plug-in, such that the circuit connection or disconnection between the battery monitoring unit 61 and the second patch cable 92 can be achieved through the plug-in and plug-off of the output port 921 or the connector 611, thus featuring ease of operation and helping improve the assembly efficiency of the battery device.

According to some embodiments of the present application, optionally, the connection wire harness 70 is at least one of a flexible circuit board and a wire harness.

For example, a plurality of connection wire harnesses 70 are present. The plurality of connection wire harnesses 70 are flexible circuit boards. The connection wire harness 70 may include a first end part 71 and a second end part 72 which are led out from the flexible circuit board. The first end part 71 is connected to the conductive part 33, and the second end part 72 is connected to the battery monitoring unit 61. Furthermore, the connection wire harness 70 may be a flexible flat cable (FFC).

For example, a plurality of connection wire harnesses 70 are present, and the plurality of connection wire harnesses 70 are wire harnesses.

For another example, a plurality of connection wire harnesses 70 are present, and the plurality of connection wire harnesses 70 may include several flexible circuit boards and several wire harnesses.

The lengths of the plurality of connection wire harnesses 70 extending in the second direction are not equal. A part of the connection wire harness 70 are connected to the conductive parts 33 of the battery cells 30 that are distal to the battery monitoring unit 61, and the lengths of such connection wire harnesses 70 are greater. A part of the connection wire harness 70 are connected to the conductive parts 33 of the battery cell 30 that are proximal to the battery monitoring unit 61, and the lengths of such connection wire harnesses 70 are less.

In the above technical solution, the connection wire harness 70 is at least one of a flexible circuit board and a wire harness. The good flexibility of the connection wire harness 70 allows the arrangement of the connection wire harness 70 in the irregular structural space between the end parts of the plurality of housings 31 and the battery monitoring unit 61, thus featuring good adaptability and saving the mounting space of the connection wire harness 70.

As shown in FIG. 12, according to some embodiments of the present application, optionally, all the battery cells 30 are disposed in series, and the battery monitoring unit 61 acquires the parameters of the battery cells 30 through the sampling part connected to the conductive parts 33. The sampling assembly 80 includes the battery monitoring unit 61 and a plurality of sampling parts connected to the battery monitoring unit 61.

Specifically, the battery cell 30 includes two conductive parts 33. The two conductive parts 33 are separately disposed at the two end parts of the housing 31 in the second direction, and the two conductive parts 33 are a positive electrode conductive part 33 and a negative electrode conductive part 33. The plurality of battery cells 30 in the battery cell assembly 20 are arranged in the first direction, and the positive electrode conductive part 33 (or the negative electrode conductive part 33) of the previous battery cell 30 is electrically connected to the negative electrode conductive part 33 (or the positive electrode conductive part 33) of the next battery cell 30 in the first direction, such that the plurality of battery cells 30 in the battery cell assembly 20 are sequentially connected in series.

The battery device 100 may include a plurality of battery cell assemblies 20. The plurality of battery cell assemblies 20 may be arranged in the second direction and all connected in series, and the plurality of battery cells 30 in each battery cell assembly 20 are all arranged in series. For example, the two battery cells 30 at the front or the rear in the first direction of two adjacent battery cell assemblies 20 in the second direction are connected in series.

In the above technical solution, all the battery cells 30 are connected in series, such that the battery device 100 has a higher output voltage, and all the battery cells 30 are connected in series to form a unidirectional series path of a plurality of the battery cells 30, thereby facilitating the sampling part to collect the parameters of pouch battery cells, and also facilitating the simplification of the algorithm for processing the collected parameters of the battery cells 30 by the battery management system.

As shown in FIG. 12, according to some embodiments of the present application, optionally, in the series path of a plurality of the battery cells 30, the number of the battery cells 30 between at least two adjacent sampling parts is greater than or equal to two.

Specifically, all the battery cells 30 in the battery device 100 may be disposed in series, thus forming a unidirectional series path of the plurality of battery cells 30. Several sampling parts are disposed on the series path of the plurality of battery cells 30, and the sampling parts may be connected to the conductive parts 33 and collect the parameters such as voltage and current at corresponding positions of the conductive parts 33 in the series path of the plurality of battery cells 30. For example, in the current direction of the series path of the plurality of battery cells 30, the number of the battery cells 30 between two adjacent sampling parts may be one, two, three, four, six, or more, and the number of the battery cells 30 between every two adjacent sampling parts may be unequal, where two or more battery cells 30 are present between at least one pair of two adjacent sampling parts.

In the above technical solution, two adjacent sampling parts in the series path of a plurality of the battery cells 30 may acquire parameters of the battery cells 30 between the two sampling parts. There are at least two adjacent sampling parts in the battery device 100 that can acquire parameters of two or more battery cells 30, such that the number of the sampling parts may be correspondingly reduced, and thus the wire harness connected to the sampling parts may also be shortened and simplified, thereby saving the mounting space and further improving the cost-efficiency to a certain extent.

As shown in FIG. 12, according to some embodiments of the present application, optionally, in the series path of a plurality of the battery cells 30, the two conductive parts 33 of the first battery cell 30 and the last battery cell 30 are connected to the sampling parts.

Specifically, each battery cell 30 includes one positive electrode conductive part 33 and one negative electrode conductive part 33, and the positive electrode conductive part 33 and the negative electrode conductive part 33 may be separately disposed at the end parts of the battery cell 30 in the second direction. In the series path of the plurality of battery cells 30, the positive electrode conductive part 33 of the previous battery cell 30 is connected to the negative electrode conductive part 33 of the next battery cell 30, or the negative electrode conductive part 33 of the previous battery cell 30 is connected to the positive electrode conductive part 33 of the next battery cell 30, such that all the battery cells 30 are sequentially connected in series.

A plurality of the sampling parts are present, where the first sampling part is connected to the conductive part 33 of the first battery cell 30 in the series path of the plurality of battery cells 30 that is not connected to the next battery cell 30, and the last sampling part is connected to the conductive part 33 of the last battery cell 30 in the series path of the plurality of battery cells 30 that is not connected to the previous battery cell 30. That is, the first sampling part and the last sampling part are provided at the start and the end of the series path of the plurality of battery cells 30, respectively.

In the above technical solution, in the series path of a plurality of the battery cells 30, the conductive parts 33 of the first battery cell 30 and the last battery cell 30 are connected to the sampling parts, so as to ensure that the sampling parts can acquire the parameters of the first battery cell 30 and the last battery cell 30, ensure the comprehensiveness of the sampling, and further facilitate the improvement of the reliability of the management strategy of the battery management system.

As shown in FIG. 12, according to some embodiments of the present application, optionally, in the series path of a plurality of the battery cells 30, between the first battery cell 30 and the last battery cell 30, two battery cells 30 are provided between two adjacent sampling parts.

Specifically, in the series path of a plurality of the battery cells 30, between the first battery cell 30 and the last battery cell 30, two battery cells 30 are provided between every two adjacent sampling parts, and the every two adjacent sampling parts can collect the parameters of the two battery cells 30 therebetween. The sampling parts can transmit the parameters of the battery cells 30 to the battery management system through the battery monitoring unit 61. The battery management system can acquire the estimated parameters of each battery cell 30 between the first battery cell 30 and the last battery cell 30 by performing operation processing on the parameters of every two battery cells 30 between the first and last battery cells 30.

Illustratively, in the series path of a plurality of the battery cells 30, every two adjacent sampling parts may collect a total voltage of the battery cells 30 between the two adjacent sampling parts, and the average voltage can be acquired according to the total voltage and the number of the battery cells 30 between the two adjacent sampling parts; the average voltage is used as the voltage parameter of each battery cells 30.

Optionally, the specifications of the plurality of battery cells 30 in the battery device 100 are identical. As such, the accuracy of the battery management system to acquire the estimated parameters of each battery cell 30 can be improved.

In the above technical solution, in the series path of a plurality of the battery cells 30, between the first battery cell 30 and the last battery cell 30, two battery cells 30 are provided between two adjacent sampling parts. Compared with the case that the sampling parts are separately arranged at both ends of each battery cell 30, the number of the sampling parts is reduced, and the sampling parts can be connected to the battery monitoring unit 61 by using shortened wire harnesses, thus saving the mounting space and further improving the cost-efficiency to a certain extent.

Optionally, the number of the battery cells 30 between every two adjacent sampling parts is unequal, where the numbers of the battery cells 30 between several pairs of two adjacent sampling parts are one, and the numbers of the battery cells 30 between several other pairs of two adjacent sampling parts are greater than or equal to two.

For example, the first sampling part and the second sampling part in the series path of a plurality of the battery cells 30 are connected to the two conductive parts 33 of the first battery cell 30, respectively, and the last two sampling parts are separately connected to the two conductive parts 33 of the last battery cell 30.

In the above technical solution, the numbers of the battery cells 30 between several pairs of two adjacent sampling parts are one, and the numbers of the battery cells 30 between several other pairs of two adjacent sampling parts are greater than or equal to two, such that the sampling precision is improved while the wire harness is shortened and the number of the sampling parts is reduced.

As shown in FIG. 13, according to some embodiments of the present application, optionally, the number of the battery cell assemblies 20 is at least two, where the two conductive parts 33 of each battery cell 30 in one battery cell assembly 20 are provided with the sampling parts.

For example, the two battery cells 20 are arranged in the second direction, and every two adjacent battery cells 30 in the second direction are connected in series, where all the battery cells 30 in one battery cell assembly 20 are sequentially connected in series through the battery cells 30 in the other battery cell assembly 20.

For example, the two conductive parts 33 of each battery cell 30 in one battery cell assembly 20 of the two battery cell assemblies 20 are provided with the sampling parts, and the two conductive parts 33 of every two battery cells 30 distal to each other in the series path of a plurality of the battery cells 30 in the other battery cell assembly 20 of the two battery cell assemblies 20 are provided with the sampling parts.

In the above technical solution, the number of the battery cell assemblies 20 is at least two, which may increase the overall output voltage of the battery device, where the two conductive parts 33 of each battery cell 30 in one battery cell assembly 20 are provided with the sampling part, and each battery cell 30 in the battery cell assembly 20 can be separately sampled, thereby improving the sampling precision, and facilitating the battery management system to accurately adjust the battery management strategy according to the sampled parameters.

According to some embodiments of the present application, optionally, the conductive parts 33 of two adjacent battery cells 30 arranged in the second direction are connected and provided with the sampling parts.

In the above technical solution, the conductive parts 33 of two adjacent battery cells 30 arranged in the second direction are connected, such that the electrical connection member between the battery cells 30 can be omitted or reduced, thus reducing the number of parts in the battery cell assembly 20, saving the space occupied by the electrical connection members, and helping improve the energy density of the battery cell assembly 20. The conductive parts 33 connected to each other of two adjacent battery cells 30 arranged in the second direction are provided with the sampling part that can acquire the parameters of the two adjacent battery cells 30 in the second direction, thus improving the sampling precision, increasing the diversity of sampling manners, and improving the decision reliability of the battery management system.

As shown in FIGs. 7 and 12, according to some embodiments of the present application, optionally, the at least one conductive part 33 of each battery cell 30 is electrically connected to the battery monitoring unit 61 through the connection wire harness 70. The connection wire harness 70 includes a first end part 71 and a second end part 72 that are opposite; the first end part 71 forms the sampling part.

Specifically, the two ends of each battery cell 30 in the second direction are separately provided with the conductive part 33, and the battery monitoring unit 61 is located on one side of the battery cell assembly 20 in the second direction. The connection wire harness 70 may extend in the second direction, and the second end part 72 and the first end part 71 are two end parts of the connection wire harness 70 opposite to each other in the second direction. The first end part 71 is welded or bonded to the conductive part 33 of the battery cell 30 to form the sampling part. A plurality of the connection wire harnesses 70 are present, and the number of the connection wire harnesses 70 is less than or equal to the number of the conductive parts 33 and greater than or equal to the number of the battery cells 30.

In the above technical solution, at least one conductive part 33 of each battery cell 30 is electrically connected to the battery monitoring unit 61 through the connection wire harness 70, and the second end part 72 of the connection wire harness 70 forms the sampling part and is connected to the conductive part 33, such that the battery monitoring unit 61 can acquire parameters of each battery cell 30 through the sampling part and the connection wire harness 70, thereby improving sampling precision and facilitating the battery management system to accurately adjust the battery management strategy.

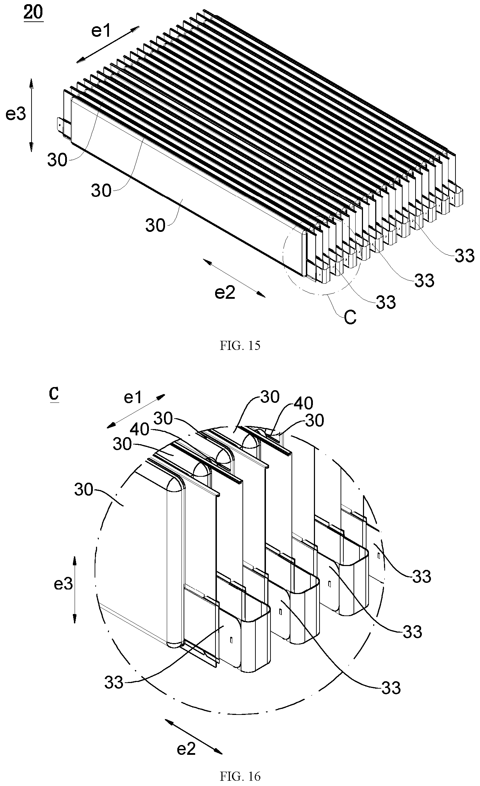

As shown in FIGs. 15-17, according to some embodiments of the present application, optionally, the housing 31 is made of a soft outer packaging material; in the first direction, a reinforcing partition plate 40 is sandwiched between at least two adjacent battery cells 30 and connected to the housing 31; the hardness of the reinforcing partition plate 40 is greater than that of the housing 31. In this embodiment, the battery cell 30 is a pouch battery cell.

For example, the reinforcing partition plate 40 may be a metal plate and the flexible shell may be an aluminum-plastic film.

The reinforcing partition plate 40 is sandwiched between two adjacent battery cells 30, including the following cases: the reinforcing partition plate 40 is provided between a part of adjacent battery cells 30, and no reinforcing partition plate 40 is provided between the another part of adjacent battery cells 30; or, the reinforcing partition plate 40 is arranged between every two adjacent battery cells 30.

The reinforcing partition plate 40 and the flexible shell of the battery cell 30 may be fixed by adhesion.

In the above technical solution, disposing the reinforcing partition plate 40 between adjacent battery cells 30 and providing the reinforcing partition plate 40 with a hardness greater than that of the flexible shell can conveniently achieve the assembly of a plurality of battery cells 30 and improve the overall rigidity of the battery cell assembly 20 formed by the assembly of the plurality of battery cells 30, thus facilitating the mounting of the battery cell assembly 20 formed by the assembly of the plurality of battery cells 30 and reducing the deformation of the battery cells 30 after the assembly.

According to some embodiments of the present application, optionally, the thickness of the reinforcing partition plate 40 is less than that of the battery cell 30.

The thickness direction of the reinforcing partition plate 40 coincides with the thickness direction of the battery cell 30. The battery cell 30 may be disposed in a posture where the thickness direction thereof is parallel to the first direction and substantially perpendicular to the third direction.

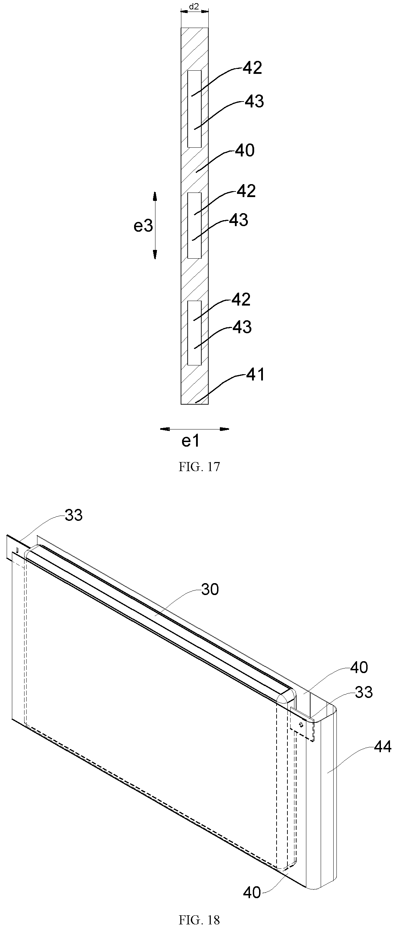

For example, as shown in FIG. 17, the reinforcing partition plate 40 has a thickness d2, the battery cell 30 has a thickness d3, and d2 is less than d3. For example, d2 ranges from 0.8 mm to 2.0 mm; for example, d2 is 0.8 mm, 1.0 mm, 1.2 mm, 1.4 mm, 1.6 mm, 1.8 mm, 2.0 mm, and the like.

In the above technical solution, providing the reinforcing partition plate 40 with a thickness less than that of the battery cell 30 can reduce the occupied space of the reinforcing partition plate 40, especially the occupied space of the reinforcing partition plate 40 in the thickness direction of the battery cell 30, while improving the overall rigidity of the assembly of the plurality of battery cells 30, so as to increase the overall energy density of the battery device 100.

According to some embodiments of the present application, optionally, the reinforcing partition plate 40 is a metal plate.

In some embodiments, the reinforcing partition plate 40 is an aluminum plate, an aluminum alloy plate, a copper plate, or a steel plate.

In the above technical solution, by configuring the reinforcing partition plate 40 with an aluminum plate, an aluminum alloy plate, a copper plate, a steel plate, or the like, the reinforcing partition plate 40 may have high strength and hardness, thus better improving the overall rigidity of the assembly of the plurality of battery cells 30 and better reducing the deformation of the assembled battery cells 30.

According to some embodiments of the present application, optionally, the reinforcing partition plate 40 is a thermally conductive member and is thermo-conductively connected to the housing 31.

For example, the reinforcing partition plate 40 and the housing 31 may be thermo-conductively connected by a thermally conductive adhesive. Since the reinforcing partition plate 40 is a thermally conductive member, the reinforcing partition plate 40 can conduct heat to the battery cell 30 or can absorb the heat generated by the battery cell 30, so as to adjust the temperature of the battery cell 30.

In the above technical solution, by configuring the reinforcing partition plate 40 as a thermally conductive member and thermo-conductively connecting same to the housing 31, the reinforcing partition plate 40 may have heat management functionality, while enhancing the overall rigidity of the assembly of the battery cells 30. Through the heat exchange of the reinforcing partition plate 40 and the battery cells 30, the temperature of the battery cells 30 can be adjusted, making the battery cells 30 work in a proper temperature range.

According to some embodiments of the present application, optionally, the reinforcing partition plate 40 is of a solid structure.

For example, the reinforcing partition plate 40 may be a solid aluminum plate, aluminum alloy plate, copper plate, or steel plate.

In the above technical solution, the configuration of the reinforcing partition plate 40 into a solid structure can provide the reinforcing partition plate 40 with good structural strength and rigidity, and allow the reinforcing partition plate 40 to effectively exert the reinforcing effects with a lower reinforcing partition plate thickness, thus providing a high volumetric energy density while providing the battery cell assembly 20 with good strength and rigidity.

According to some embodiments of the present application, optionally, a cavity 42 is formed in the reinforcing partition plate 40.

For example, as shown in FIG. 17, a plurality of cavities 42 spaced apart may be formed in the reinforcing partition plate 40. The plurality of cavities 42 in the reinforcing partition plate 40 may be arranged and spaced apart in the width direction of the battery cells 30, and each cavity 42 may extend in the length direction of the battery cells 30.

In the above technical solution, the arrangement of the cavity 42 in the reinforcing partition plate 40 provides clearance for the expansion and deformation of the battery cells 30 while allowing the reinforcing partition plate 40 to enhance the overall rigidity of the assembled battery cells 30. The cavity 42 in the reinforcing partition plate 40 can buffer the deformation of the adjacent battery cells 30 and is desirable for reducing the weight of the reinforcing partition plate 40.

As shown in FIG. 17, according to some embodiments of the present application, optionally, the cavity 42 includes a heat exchange flow channel 43 for the flow of a heat exchange medium.

The reinforcing partition plate 40 may serve as at least a part of a heat management member when at least a part of the cavity 42 of the reinforcing partition plate 40 serves as a heat exchange flow channel 43.

For example, the reinforcing partition plate 40 may be connected to the battery cell 30 through a thermally conductive adhesive, such that the heat exchange between the reinforcing partition plate 40 and the battery cell 30 may be conveniently achieved. In the process of the heat exchange medium flowing through the heat exchange flow channel 43, the temperature of the battery cell 30 can be adjusted; for example, the temperature of the battery cell 30 may be increased or decreased.

In the above technical solution, at least a part of the cavity 42 in the reinforcing partition plate 40 forms the heat exchange flow channel 43. The heat exchange medium can flow through the heat exchange flow channel 43 in the reinforcing partition plate 40 and exchange heat with the battery cell 30, so as to achieve the effective adjustment of the temperature of the battery cells 30.

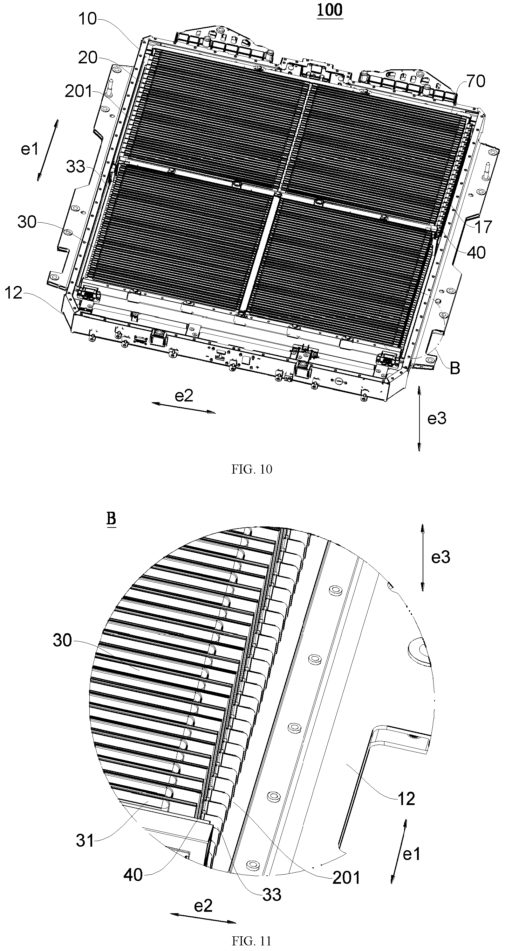

As shown in FIGs. 11 and 17, according to some embodiments of the present application, optionally, the reinforcing partition plate 40 includes a connecting part 41 protruding from the housing 31 in the second direction, and the connecting part 41 is located on the side of the conductive part 33 distal to the battery monitoring unit 61.

When the cavity 42 is formed in the reinforcing partition plate 40, the cavity 42 may not extend to the connecting part 41. That is, the connecting part 41 may be of a solid structure.

In the above technical solution, by configuring the end part of the reinforcing partition plate 40 in the second direction to protrude from the housing 31 of the battery cell 30 and connecting same to the case 10, since the reinforcing partition plate 40 is sandwiched between the plurality of battery cells 30 and forms the battery cell assembly 20 with the plurality of battery cells 30 and the hardness of reinforcing partition plate 40 is generally greater than that of the housing 31 of battery cells 30, the battery cell assembly 20 generally possesses good strength and rigidity.

In some embodiments, the connecting part 41 may be connected to the case 10. As such, the connecting part 41 is connected to the case 10 for achieving the connection and fixation between the battery cell assembly 20 and the side wall of the case 10. The configuration of the connecting part 41 into a solid structure can make the connection between the battery cell assembly 20 and the case 10 more reliable, thereby improving the mounting reliability and stability of the battery cell assembly 20 in the case 10.

As shown in FIG. 18, according to some embodiments of the present application, optionally, in the first direction, two adjacent reinforcing partition plates 40 are connected by a connecting plate 44, and the battery cell 30 is accommodated in a space defined by the connecting plate 44 and the two reinforcing partition plates 40 in an enclosing manner.

Specifically, the connecting plate 44 connects the end parts of the two reinforcing partition plates 40 on the same side in the second direction. The connecting plate 44 may be a flat plate or a less curved plate, and the connecting plate 44 is generally parallel to the first direction. The connecting plate 44 and the two reinforcing partition plates 40 connected to the connecting plate 44 may be assembled to form a "U"-shaped frame and surround the battery cell 30 between the two reinforcing partition plates 40.

In the above technical solution, two adjacent reinforcing partition plates 40 are connected by a connecting plate 44, and the battery cell 30 is accommodated in a space defined by the connecting plate 44 and the two reinforcing partition plates 40 in an enclosing manner, thereby improving the strength of the reinforcing partition plates 40 and further increasing the mounting reliability and the stability of battery cells 30.

As shown in FIG. 18, according to some embodiments of the present application, optionally, the two adjacent reinforcing partition plates 40 in the first direction, along with the connecting plate 44 connected thereto, are integrally formed.

As an example, every two adjacent heating partition plates in the first direction are fixedly connected to, and may be integrally formed with, the connecting plate 44 between the two reinforcing partition plates 40.

In the above technical solution, the two adjacent reinforcing partition plates 40 in the first direction and the connecting plate 44 connected between the two reinforcing partition plates 40 are molded into an integral structure, so as to further increase the strength of the reinforcing partition plate 40 and improve the mounting reliability and the structural stability of the battery cells 30.

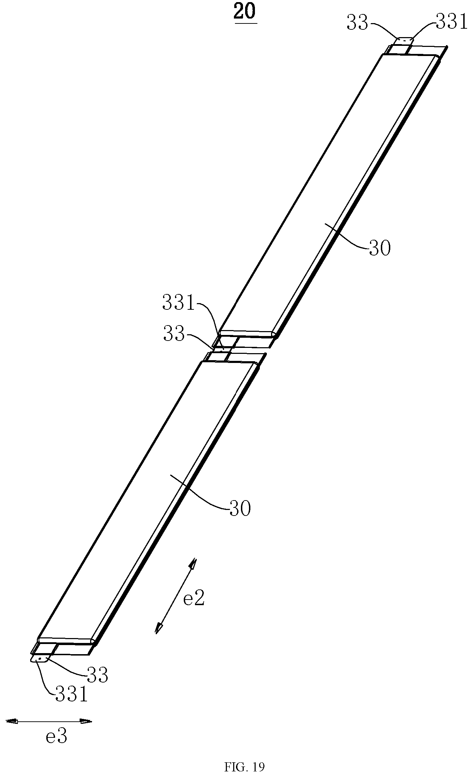

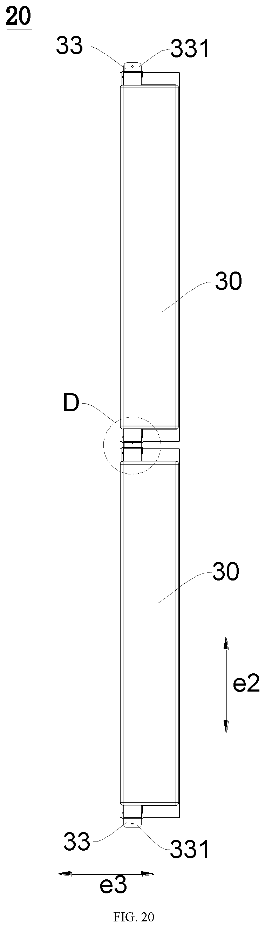

As shown in FIGs. 19-21, according to some embodiments of the present application, optionally, the conductive parts 33 of the two adjacent battery cells 30 are directly connected.

It should be noted that the conductive parts 33 of two adjacent battery cells 30 are directly connected. The outer portion of the conductive part 33 exposed outside the housing 31 is defined as the lead-out part 331, and the conductive parts 33 of two adjacent battery cells 30 are directly connected, which means that actually, the lead-out parts 331 of the two conductive parts 33 are directly connected.

The "direct connection" in the direct connection of the conductive parts 33 of two adjacent battery cells 30 means that the conductive parts 33 of the two battery cells 30 are directly connected without being connected by an electrical connection member to achieve the electrical connection of two adjacent battery cells 30.

The electrical connection between the two adjacent battery cells 30 may be a series connection.

In the above technical solution, the direct connection of the conductive parts 33 of two adjacent battery cells 30 in the battery cell assembly 20 can omit or reduce the electrical connection member between the battery cells 30, thus reducing the number of parts in the battery cell assembly 20, saving the space occupied by the electrical connection members, and helping improve the energy density of the battery cell assembly 20. The omission or reduction of the electrical connection member between the battery cells 30 may further improve the cost-efficiency.

According to some embodiments of the present application, optionally, the conductive parts 33 of the two adjacent battery cells 30 are connected by welding.

For example, the welding connection between the conductive parts 33 of two adjacent battery cells 30 may be a laser welding connection or an ultrasonic welding connection.

In the above technical solution, the welding connection between the conductive parts 33 of the two adjacent battery cells 30 in the battery cell assembly 20 achieves the direct connection of the terminals of the two adjacent battery cells 30 in the battery cell assembly 20, thus providing a simple and reliable connection of the conductive parts 33 of the two adjacent battery cells 30 in the battery cell assembly 20.

According to some embodiments of the present application, optionally, the conductive parts 33 of the two adjacent battery cells 30 are directly connected by a conductive adhesive.

In some embodiments, the conductive parts 33 of the two adjacent battery cells 30 are directly connected by a conductive adhesive.

For example, a conductive adhesive may be applied to one conductive part 33 of one battery cell 30 of the two adjacent battery cells 30, and the conductive part 33 of the other battery cell 30 of the two adjacent battery cells 30 may be connected to the conductive part 33 coated with the conductive adhesive; alternatively, the conductive adhesive may be applied to the conductive parts 33 of the two adjacent battery cells 30, and the two conductive parts 33 coated with the conductive adhesive may be connected by the conductive adhesive.

In the above technical solution, the conductive adhesive connection between the conductive parts 33 of the two adjacent battery cells 30 in the battery cell assembly 20 achieves the direct connection of the terminals of the two adjacent battery cells 30 in the battery cell assembly 20, thus providing a simple and reliable connection of the conductive parts 33 of the two adjacent battery cells 30 in the battery cell assembly 20.

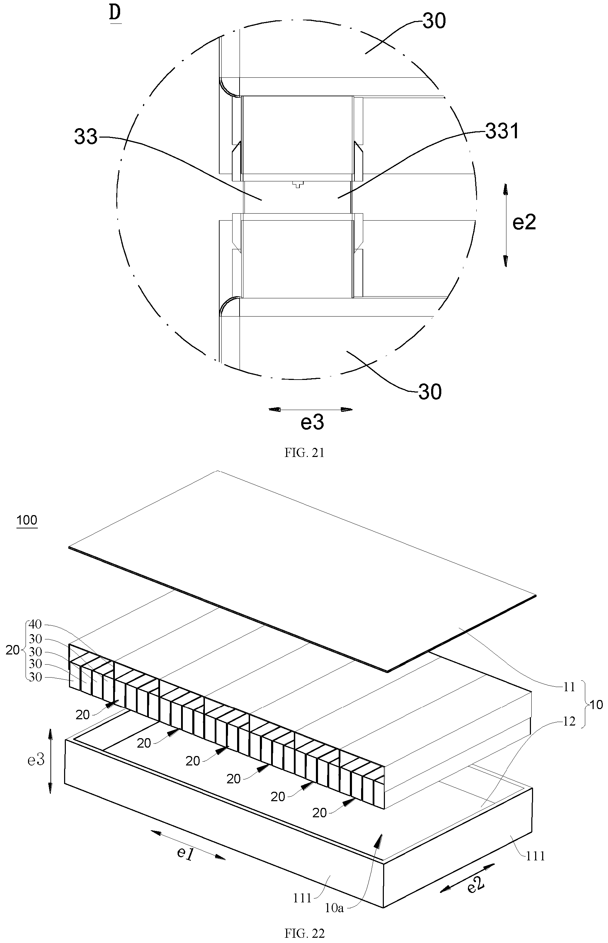

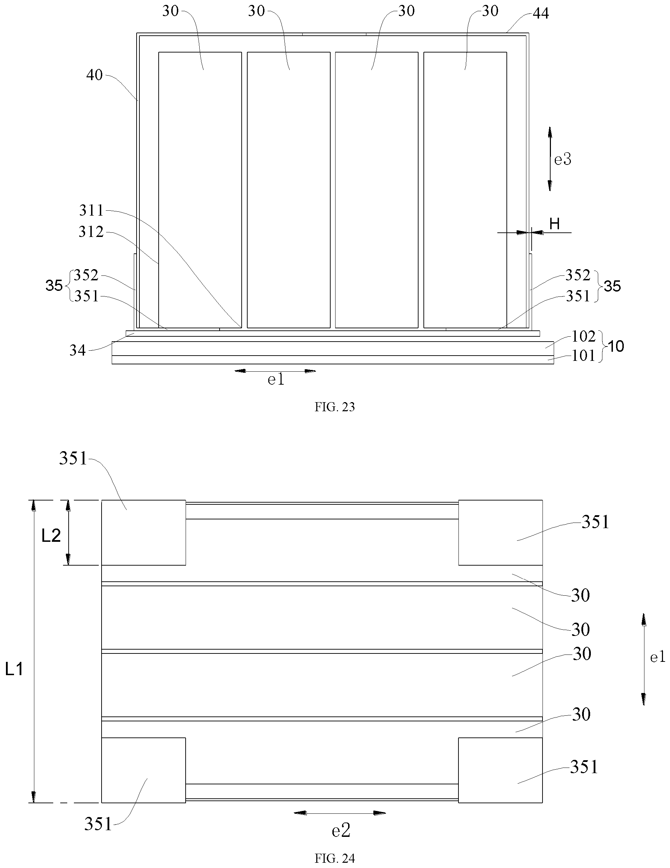

As shown in FIGs. 22 and 23, according to some embodiments of the present application, optionally, a plurality of the battery cells 30 are sequentially coupled by bonding in the first direction; the battery cell 30 is provided with a first surface 311 and a second surface 312, and the second surface 312 is adjacent to the first surface 311.

The battery device 100 includes the case 10, an adhesive layer 34, and a blocking member 35. The adhesive layer 34 is arranged on the side of the first surface 311 of the battery cell assembly 20 and configured for bonding a plurality of the battery cells 30 to the case 10. The blocking member 35 is at least located between at least one of the battery cells 30 at the two ends of the battery cell assembly 20 in the first direction and the adhesive layer 34, and configured for preventing the adhesive layer 34 from overflowing from the first surface 311 of the battery cell 30 to the second surface 312 of the corresponding battery cell 30.

Specifically, the adhesive layer 34 may refer to a layered structure formed by an adhesive with bonding functionality.

The blocking member 35 may refer to a structure or a component configured for preventing the adhesive layer 34 from overflowing from the first surface 311 of the battery cell 30 to the second surface 312 of the corresponding battery cell 30. Illustratively, the blocking member 35 may be L-shaped and may partially cover the first surface 311, thereby blocking the adhesive from overflowing to the second surface 312; the blocking member 35 may also be a flat plate with a part covering the first surface 311 and another part exceeding the second surface 312, such that when the adhesive overflows, the overflowing adhesive can be located on the another part of the blocking member 35 without contacting the second surface 312, thereby also exerting the overflow-preventing functionality.

The first surface 311 and the second surface 312 may refer to two surfaces of the battery cell 30. The first surface 311 may be, but is not limited to, the bottom surface, the top surface, a side surface, or the like of the battery cell 30, and may be fixed to the case 10 by the adhesive layer 34. The second surface 312 may refer to a surface disposed adjacent to the first surface 311, and a plurality of second surfaces 312 may be present. For example, the second surface 312 may be located at one end or two ends in the first direction e1 of the first surface 311, may be located at one end or two ends in the second direction e2 of the first surface 311, and may be located at one end or two ends in the first direction e1 and one end or two ends in the second direction e2 of the first surface 311. The second direction e2 may refer to the other one of the length direction or the width direction of the case 10. Illustratively, the first direction e1 may refer to the length direction of the case 10, and the second direction e2 may refer to the width direction of the case 10.

In the battery device 100 with the above structure, in the assembling stage, the adhesive is applied between the first surfaces 311 of the plurality of battery cells 30 of the battery cell assembly 20 and the case 10 to form the adhesive layer 34. Since the blocking member 35 is at least located between at least one of the battery cells 30 at the two ends of the battery cell assembly 20 in the first direction e1 and the adhesive layer 34, in the process of applying the adhesive, the blocking member 35 can effectively reduce the risk that adhesive overflows from the first surface 311 to the second surface 312, such that the possibility of the adhesive overflow on the second surface 312 of the battery cell 30 to form a hard structure can be effectively reduced, and the risk of concentrated local stress due to the contact between the surface of the battery cell 30 and the hard structure can be reduced when the battery cell 30 expands or displaces, thereby helping reduce the probability of damage to the battery cell 30.

Secondly, the first surface 311 of the battery cell 30 may be spaced apart from the case 10 by the adhesive layer 34, such that the battery cell 30 and the case 10 are not in contact with each other, and thus the adhesive layer 34 may exert insulating functionality. Since the blocking member 35 is at least located between at least one of the battery cells 30 at the two ends of the battery cell assembly 20 in the first direction e1 and the adhesive layer 34, the blocking member 35 can increase the distance between the first surface 311 of the battery cell 30 and the case 10. That is, the insulation gap between the first surface 311 and the case 10 is increased, which is also beneficial to increasing the thickness of the adhesive layer 34 and further improving the insulation between the battery cell 30 and the case 10.

In the above technical solution, the arrangement of the blocking member 35 between at least one battery cell 30 at least located at two ends of the battery cell assembly 20 in the first direction e1 and the adhesive layer 34 can reduce the risk that the adhesive overflows from the first surface 311 of the battery cell 30 to the second surface 312 when applying the adhesive in the assembly stage of the battery device 100, and reduce the probability that the adhesive overflows from the second surface 312 of the battery cell 30 to form a hard structure, thus alleviating the problem of concentrated local stress on the surface of the battery cell 30 and the risk of damage to the battery cell 30, and improving the insulation between the first surface 311 of the battery cell 30 and the case 10, the reliability of the battery cell 30, and the reliability of the battery device 100.

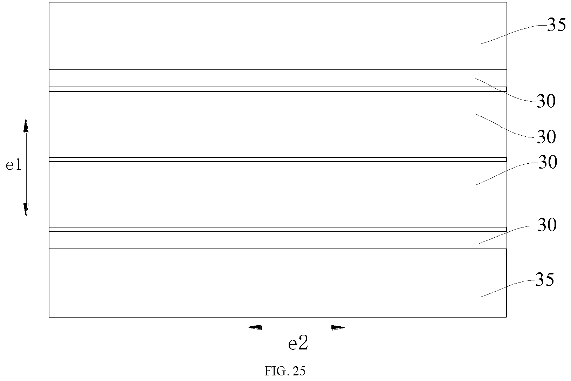

As shown in FIGs. 24 and 25, according to some embodiments of the present application, optionally, the blocking member 35 covers at least a corner position of the corresponding battery cell 30.

It will be appreciated that the blocking members 35 may cover the first surfaces 311 of all the battery cells 30 in the battery cell assembly 20, may cover only the first surfaces 311 of the battery cells 30 at the two ends in the first direction e1, or may cover only the corner positions of the first surfaces 311 of the battery cells 30 at the two ends in the first direction e1. In all of the above three cases, the blocking member 35 can satisfy the requirement of at least covering the corner position of the corresponding battery cell 30.

When the adhesive is applied to the first surfaces 311 of all the battery cells 30 of the battery cell assembly 20, the adhesive spreads in the first direction e1 and the second direction e2 and is accumulated at the four corner positions of the battery cell assembly 20, such that the probability of adhesive overflow at the corner positions of the battery cell assembly 20 is greater than at other positions.

In the above technical solution, by covering the corner position of the corresponding battery cell 30 with the blocking member 35, the probability that the adhesive accumulates at the corner position of the outermost battery cell 30 can be effectively reduced, thus achieving the effect of preventing adhesive overflow, reducing the size of the blocking member 35 and materials, saving a proper space on the first surface 311 for applying the adhesive, and improving the bonding fastness of battery cell 30 and case 10.

As shown in FIG. 25, according to some embodiments of the present application, optionally, the blocking member 35 covers at least an edge position of the corresponding battery cell 30 in the first direction e1.

It will be appreciated that in the above technical solution, the blocking members 35 may cover the first surfaces 311 of all the battery cells 30 in the battery cell assembly 20, may cover only the first surfaces 311 of the battery cells 30 at the two ends in the first direction e1, or may cover an edge position of the corresponding battery cell 30 in the first direction e1. In all of the above three cases, the blocking member 35 satisfies the requirement of covering the edge position of the corresponding battery cell 30 in the first direction e1.

Since the plurality of battery cells 30 are arranged in the first direction e1, the second surfaces 312 of the battery cells 30 at the two ends in the first direction e1 are generally large surfaces. By adopting the above technical solution, the blocking member 35 can reduce the risk of adhesive overflow to the second surface 312 at the corner position of the battery cell 30, reduce the risk of adhesive overflow to the large surfaces of the battery cell 30, and reduce the probability of the formation of hard structures on the large surfaces of the battery cell 30 after the solidification of the overflowing adhesive, so as to further reduce the risk of damage to the battery cell 30.

In the above technical solution, the blocking member 35 can reduce the risk that the adhesive overflows to the second surface 312 of the battery cell 30 with a greater area, thus further reducing the risk of adhesive overflow at the edge of the battery cell assembly 20, the formation of a hard structure and damage to the battery cell 30, and improving the reliability of the battery device 100.

In some embodiments of the present application, as shown in FIG. 24, the blocking member 35 is provided at the two ends of the battery cell assembly 20 in the first direction e1, and in the first direction e1, the dimension of the battery cell assembly 20 is L1, and the dimension of the blocking member 35 is L2, where 0.05 ≤ L2/L1.

L2/L1 may be, but is not limited to, 0.05, 0.07, 0.09, 0.10, 0.12, 0.15, 0.17, 0.2, 0.25, 0.3, etc. That is, a proper dimension of the blocking member 35 can be selected according to the value of dimension L1 of the battery cell assembly 20. Illustratively, dimension L2 of the blocking member 35 in the first direction e1 may be 5 mm, 6 mm, 7 mm, etc.

It will be appreciated that L2/L1 shall satisfy a minimum requirement of greater than or equal to 0.05. When L2/L1 is less than 0.05, the size of the portion of the blocking member 35 corresponding to the first surface 311 is relatively small, the area of the blocking member 35 covering the first surface 311 is relatively small, the solid portion of the blocking member 35 to block the adhesive may be insufficient, thus leading to an increased risk of the adhesive overflowing from the blocking member 35 to the second surface 312 and failure of the adhesive overflow prevention effects. Moreover, the smaller size of the portion of the blocking member 35 corresponding to the first surface 311 may also increase the risk of sharp objects penetrating the first surface 311 and lead to failure of the protection effects.

In the above technical solution, the configuration of the dimension ratio of blocking member 35 to the battery cell assembly 20 in the first direction e1 in the above range can make the size of the blocking member 35 corresponding to the first surface 311 fall within a proper range, which not only prevents the adhesive from overflowing from the first surface 311 to the second surface 312, but also exerts good protection effects and reduces the risk of sharp objects contacting the first surface 311 to damage the battery cell 30, thus improving the reliability of the battery device 100.

In some embodiments of the present application, the area of the orthographic projection area of the blocking member 35 on the plane of the first surface 311 is greater than or equal to the areas of all first surfaces 311.

In some embodiments of the present application, as shown in FIG. 23, the blocking member 35 includes a first part 351 and a second part 352 that are connected. The first part 351 covers at least a portion of the first surface 311, and the second part 352 is folded back relative to the first part 351 in a direction away from the adhesive layer 34.

It will be appreciated that the second part 352 is disposed at an included angle relative to the first part 351, and the angle between the two can be set as desired. Illustratively, the included angle between the second part 352 and the first part 351 is an obtuse angle, where the blocking member 35 may be configured in a V-shape; the angle between the second part 352 and the first part 351 may also be a right angle, where the blocking member 35 may be configured in an L-shape (see FIG. 23). Optionally, the first part 351 and the first surface 311 may be connected by a manner including, but not limited to, hot-melting or bonding.

In the above technical solution, the first part 351 can increase the gap between the first surface 311 and the case 10, which is beneficial to enhancing the insulation between the battery cell assembly 20 and the case 10. The second part 352, due to the folded arrangement at an angle relative to the first part 351, may provide a better blocking effect, which is beneficial to further reducing the risk of adhesive spreading towards the second surface 312 adjacent to the first surface 311. The blocking member 35 with the above structure features a simple structure, ease to manufacture, and cost-efficiency.

In some embodiments of the present application, as shown in FIGs. 22 and 23, the battery cell assembly 20 includes the reinforcing partition plate 40 and the connecting plate 44. A plurality of battery cells 30 are disposed between two adjacent reinforcing partition plates 40 in the first direction, and the reinforcing partition plate 40 and the connecting plate 44 are formed with an opening open toward the first surface 311.

The reinforcing partition plate 40 can provide a firm external protection structure for the plurality of battery cells 30, thus reducing the risk of damage to the battery cells 30 due to external mechanical impact, ensuring the battery cells 30 being in correct positions in the case 10, and reducing the risk of poor contact due to the displacement of the battery cells 30.

In some embodiments of the present application, the blocking member 35 is made of an insulating material.

The insulating material may include, but is not limited to, a ceramic material, a glass material, a plastic material, a rubber material, a mica material, etc., where the plastic material may include, but is not limited to, polypropylene, polyetherimide, etc.

The blocking member 35 can enhance the insulation between the battery cell assembly 20 and the case 10 by increasing the gap between the first surface 311 and the case 10. On this basis, the configuration of the blocking member 35 with an insulating material imparts an insulating effect to the blocking member 35, thus further enhancing the insulation between the battery cell 30 and the case 10, reducing risks such as short circuits, and improving the reliability of the battery cell assembly 20.

In the above technical solution, the configuration of the blocking member 35 with an insulating material helps further enhance the insulation between the first surface 311 of the battery cell 30 and the case 10, and thus further improves the insulation between the battery cell assembly 20 and the case 10, thereby improving the reliability of the battery device 100.

In some embodiments of the present application, as shown in FIG. 23, the wall thickness of the blocking member 35 is H, where 1 mm ≤ H ≤ 3 mm.

H may be, but is not limited to, 1 mm, 1.2 mm, 1.4 mm, 1.6 mm, 1.8 mm, 2.0 mm, 2.2 mm, 2.4 mm, 2.6 mm, 2.8 mm, 3 mm, and the like. It will be appreciated that if H is smaller than 1 mm, the blocking member 35 may have a smaller thickness, and thus cannot achieve good protection and insulation effects. For example, a smaller thickness of the blocking member 35 may increase the risk that a processing burr of the case 10 or an external sharp object piercing the blocking member 35 and thus the battery cell 30, with a poor effect of increasing the gap between the first surface 311 and the case 10, leading to the failure in exerting good insulation effects; when the blocking member 35 is made of an insulating material, a smaller thickness of the blocking member 35 may fail to exert good insulation effects.

Considering that the processing burrs of the case 10 are generally smaller than 3 mm, if H is greater than 3 mm, the thickness of the blocking member 35 is relatively greater, which may result in excessive protection performance and an excessive gap between the first surface 311 and the case 10 far beyond the insulation requirement. When the blocking member 35 is made of an insulating material, such a thickness may also result in an insulation effect far beyond the expected insulation performance. That is, an H greater than 3 mm may result in excessive protection performance and insulation performance of the blocking member 35 and a greater occupied space, which is unfavorable for the compact design of the battery device 100 and improving the energy density of the battery device 100.

The thickness of the blocking member 35 may be selected depending on the material of the blocking member 35. Illustratively, when the blocking member 35 is made of polyetherimide (PEI), the blocking member 35 has an insulation effect while having the functionality of preventing adhesive overflow. In this case, the thickness of the blocking member 35 may be 2 mm, and the dimension of the portion corresponding to the first surface 311 in the first direction e1 may be 7 mm. When the blocking member 35 is made of aluminum, the blocking member 35 may be designed to be L-shaped, and an insulating layer is disposed on the surface. In this case, the thickness of the blocking member 35 may be 1 mm, and the dimension of the portion corresponding to the first surface 311 in the first direction e1 may be 5 mm. When the blocking member 35 is made of polypropylene (PP), the blocking member may also be designed to be L-shaped. The thickness of the blocking member 35 may be 1.5 mm, and the dimension of the portion corresponding to the first surface 311 in the first direction e1 may be 6 mm.

In the above technical solution, the configuration of the thickness of the blocking member 35 within the above range can minimize the thickness of the blocking member 35 while satisfying the protection and insulation effects, thereby saving the space occupied by the blocking member 35, reducing the weight of the blocking member 35, facilitating the compact design of the battery device 100, reducing the weight of the entire battery device 100, and improving the energy density of the battery device 100.

In some embodiments of the present application, the energy density of the battery cell 30 is E, and the melting point of the blocking member 35 is T1, where: when E ≤ 390 Wh/L, T1 > 150 °C; when E > 390 Wh/L, T1 > 200 °C.

When the energy density E of the battery cell 30 is greater than or equal to 390 Wh/L, the temperature of the battery cell 30 when thermal runaway occurs may exceed 200 °C. Therefore, the material with a melting point greater than 200 °C may be selected for the blocking member 35, so as to reduce the risk of compromised performance due to the melting of the blocking member 35 during thermal runaway, and improve the high temperature resistance of the blocking member 35. When the energy density E of the battery cell 30 is less than 390 Wh/L, the temperature of the battery cell 30 when thermal runaway occurs may be less than 150 °C. Therefore, the material with a melting point greater than 150 °C may be selected for the blocking member 35, so as to improve the cost-efficiency while satisfying the high temperature resistance of the blocking member 35.

For example, when the blocking member 35 is made of polypropylene (PP), the melting point is greater than or equal to 150 °C; when the blocking member 35 is made of polyetherimide (PEI), the melting point is greater than or equal to 250 °C; when the blocking member 35 is made of polyimide (PI), the melting point is greater than or equal to 300 °C; when the blocking member 35 is made of aluminum with an insulating layer, the melting point is greater than or equal to 660 °C; when the blocking member 35 is made of steel with an insulating layer, the melting point is greater than or equal to 1000 °C.

In the above technical solution, the configuration of the melting point of the blocking member 35 and the energy density of the battery cell 30 within the above ranges can impart a proper high temperature resistance to the blocking member 35 and improve the reliability of the blocking member 35, thereby improving the reliability of the battery device 100, the cost-efficiency of the blocking member 35, and thus the cost-efficiency of the battery device 100.

In some embodiments of the present application, as shown in FIG. 22, the case 10 includes a plurality of case walls 111. The plurality of case walls 111 collectively define the accommodating space 10a, and the first surface 311 and the blocking member 35 are bonded to the case walls 111 through the adhesive layer 34.

The case walls 111 may refer to walls forming the case 10 in an enclosing manner. The plurality of case walls 111 may include a top cover 11, a bottom plate 12, side case walls, and the like. In the above technical solution, the first surface 311 of the battery cell 30 may be bonded and fixed to one of the bottom plate 12, the top cover 11, and the side case walls through the adhesive layer 34.

In the above technical solution, the first surface 311 of the battery cell 30 and the blocking member 35 may be bonded and fixed to the case wall 111 of the case 10 through the adhesive layer 34, such that the connection between the battery cell 30 and the case 10 is firmer.

In some embodiments of the present application, as shown in FIG. 23, the case 10 includes a case body 101 and a heat exchange plate 102. The heat exchange plate 102 is connected to the case body 101 and defines the accommodating space 10a collectively with the case body 101. The first surface 311 and the blocking member 35 are bonded to the heat exchange plate 102 through the adhesive layer 34.

The heat exchange plate 102 may refer to a component that may exchange heat with the battery cell 30 to adjust the temperature of the battery cell 30. Illustratively, the heat exchange plate 102 may be a cold plate. In this technical solution, the heat exchange plate 102 and the case body 101 may collectively form the case 10. The heat exchange plate 102 may serve as one case wall 111 of the case 10. For example, the case body 101 has no bottom wall, and the heat exchange plate 102 is connected to the bottom of the case body 101 and serves as the bottom wall of the case 10; the heat exchange plate 102 may also be provided on any one of the wall plates of the case body 101, and collectively with the corresponding wall plate, forms one case wall 111 of the case 10.

In the above technical solution, by bonding and fixing the first surface 311 of the battery cell 30 and the blocking member 35 to the heat exchange plate 102 through the adhesive layer 34, the heat exchange plate 102 can perform heat exchange with the battery cell 30 with high efficiency and rapidly adjust the temperature of the battery cell 30, thereby improving the reliability of the battery cell 30 and further improving the reliability of the battery device 100.

Optionally, the heat exchange plate 102 is provided at the bottom of the case body 101.

According to some embodiments of the present application, optionally, the battery cell 30 is any one of a lithium iron phosphate battery cell, a ternary battery cell, and a solid-state battery cell.

The solid-state battery cell may be, but is not limited to, a polymer solid-state battery cell, an oxide solid-state battery cell, a sulfide solid-state battery cell, a halide solid-state battery cell, and the like. The solid-state battery cell may also be a semisolid-state battery cell or an all-solid-state battery cell.

In the above technical solution, battery cells 30 of the above types can provide more options for the design of the battery device to meet different requirements of use. When the battery cell 30 is a lithium iron phosphate battery cell, it may feature advantages of high reliability, long cycle life, light weight, large capacity, and small internal resistance; when the battery cell 30 is a ternary battery cell, it may feature advantages of higher energy density and good electrochemical performance; when the battery cell 30 is a solid-state battery cell, it may feature advantages of high energy density, high reliability, light weight and good high/low temperature performance.

According to some embodiments of the present application, optionally, the battery cell 30 is a lithium iron phosphate battery cell, and in the positive electrode material of the battery cell 30, the ratio of a positive electrode active material, a binder, and a conductive agent is 96:(1-3):(1-3); the battery cell 30 is a ternary battery cell, and in the positive electrode material of the battery cell 30, the ratio of a positive electrode active material, a binder, and a conductive agent is 96:(2-3):(1-2).

In some embodiments, the positive electrode of the battery cell 30 may be a positive electrode plate. The positive electrode plate may include a positive electrode current collector and a positive electrode film layer disposed on at least one surface of the positive electrode current collector, and the positive electrode film layer includes a positive electrode active material.

As an example, the positive electrode current collector has two surfaces opposite to each other in the thickness direction thereof, and the positive electrode film layer is disposed on any one or both of the two opposite surfaces of the positive electrode current collector.

As an example, the positive electrode current collector may be a metal foil or a composite current collector. For example, for the metal foil, stainless steel, copper, aluminum, nickel, carbon electrode, carbon, nickel, titanium, aluminum or stainless steel treated with silver on the surface, or the like may be used. The composite current collector may include a polymer material substrate and a metal layer. The composite current collector can be fabricated by forming a metal material (aluminum, aluminum alloy, nickel, nickel alloy, titanium, titanium alloy, silver, silver alloy, etc.) on a polymer material substrate (such as a substrate made of polypropylene, polyethylene terephthalate, polybutylene terephthalate, polystyrene, and polyethylene).

As an example, when the battery cell 30 according to the embodiments of the present application is a lithium-ion battery, the positive electrode active material may include at least one of the following materials: a phosphate, a layered transition metal oxide, and a modified compound thereof; optionally, the positive electrode active material may include a layered transition metal oxide and a modified compound thereof, which is beneficial to increasing the energy density of the battery cell 30. However, the present application is not limited to these materials, and other traditional materials that can be used as positive electrode film layers for batteries may also be used. These positive electrode active materials may be used alone or in a combination of two or more.

Examples of the phosphate may include, but are not limited to, at least one of lithium iron phosphate (such as LiFePO₄ (also referred to as LFP)), a composite material of lithium iron phosphate and carbon, lithium manganese phosphate (such as LiMnPO₄), a composite material of lithium manganese phosphate and carbon, lithium manganese iron phosphate, and a composite material of lithium manganese iron phosphate and carbon.

The layered transition metal oxide includes at least one of a compound of general formula LiₐNi_{b}Co_{c}M_{d}OₑD_{f} and a modified compound thereof, where 0.8 ≤ a ≤ 1.2, 0.3 ≤ b < 1, 0 < c < 1, 0 < d < 1, 1 ≤ e ≤ 2, 0 ≤ f ≤ 1, M includes at least one of Mn, Al, Zr, Zn, Cu, Cr, Mg, Fe, V, Ti and B, and A includes at least one of N, F, S and Cl. Optionally, 0.5 ≤ b < 1, and further optionally, 0.75 ≤ b ≤ 0.98.

Examples of the layered transition metal oxide may include, but are not limited to, at least one of a lithium cobalt oxide (e.g., LiCoO₂), a lithium nickel oxide (e.g., LiNiO₂), a lithium manganese oxide (e.g., LiMnO₂, LiMn₂O₄), a lithium nickel cobalt oxide, a lithium manganese cobalt oxide, a lithium nickel manganese oxide, a lithium nickel cobalt manganese oxide (e.g., LiNi_{1/3}Co_{1/3}Mn_{1/3}O₂ (also known as NCM333), LiNi_{0.5}Co_{0.2}Mn_{0.3}O₂ (also known as NCM523), LiNi_{0.5}Co_{0.25}Mn_{0.25}O₂ (also known as NCM211), LiNi_{0.6}Co_{0.2}Mn_{0.2}O₂ (also known as NCM622), LiNi_{0.8}Co_{0.1}Mn_{0.1}O₂ (also known as NCM811), LiNi_{0.9}Co_{0.05}Mn_{0.05}O₂ (also known as Ni90), a lithium nickel cobalt aluminum oxide (e.g., LiNi_{0.80}Co_{0.15}Al_{0.05}O₂), and a modified compound thereof.

When the battery cell 30 according to the embodiments of the present application is a sodium-ion battery, the positive electrode active material may include, but is not limited to, at least one of a sodium-containing transition metal oxide, a polyanion material (such as a phosphate, a fluorophosphate, a pyrophosphate, a sulfate, etc.), and a Prussian blue material.

As an example, the positive electrode active material for a sodium-ion battery may include at least one of NaFeO₂, NaCoO₂, NaCrO₂, NaMnO₂, NaNiO₂, NaNi_{1/2}Ti_{1/2}O₂, NaNi_{1/2}Mn_{1/2}O₂, Na_{2/3}Fe_{1/3}Mn_{2/3}O₂, NaNi_{1/3}Co_{1/3}Mn_{1/3}O₂, NaFePO₄, NaMnPO₄, NaCoPO₄, a Prussian blue material, and a material of general formula XₚM'_{q}(PO₄)ᵣOₓY₃₋ₓ. In general formula XₚM'_{q}(PO₄)ᵣOₓY₃₋ₓ, 0 < p ≤ 4, 0 < q ≤ 2, 1 ≤ r ≤ 3, 0 ≤ x ≤ 2, X includes at least one of H⁺, Li⁺, Na⁺, K⁺ and NH4⁺, M' is a transition metal cation, optionally at least one of V, Ti, Mn, Fe, Co, Ni, Cu and Zn, and Y is a halogen anion, optionally at least one of F, Cl and Br.

In the embodiments of the present application, the modified compounds of the positive electrode active materials may be a compound obtained by doping modification and/or surface coating modification of the positive electrode active material, such as carbon coating modification, fast ion conductor coating modification, and the like.

The battery cell 30 is accompanied by the deintercalation and consumption of active ions such as Li during the charging and discharging process, and the molar content of Li varies when the battery cell 30 is discharged to different states. In the list of the positive electrode active materials in the embodiments of the present application, the molar content of Li refers to the initial state of the material, i.e., the state before charging. The molar content of Li may vary after charge and discharge cycles when the positive electrode active material is applied to a battery system.

In the list of the positive electrode active materials in the embodiments of the present application, the molar content of oxygen O is merely a theoretical value, and the molar content of oxygen O may vary due to oxygen release from the crystal lattice. In practice, the molar content of oxygen O fluctuates.

In the embodiments of the present application, the contents of the elements in the positive electrode active materials are concepts known in the art, and can be determined by using a device and a method known in the art, for example, determined according to EPA 6010D-2014 by an inductively coupled plasma optical emission spectroscopy system (ICP-OES, Thermo ICAP7400). First, 0.4 g of the positive electrode active material was taken, and 10 mL of 50% aqua regia was added thereto. The mixture was let to stand on a plate at 180 °C for 30 min. After digestion on the plate, the volume was brought to 100 mL, and a quantitative test was conducted by the standard curve method.

In some embodiments, a metal foam may be used for the positive electrode. The foam metal may be foam nickel, foam copper, foam aluminum, foam alloy, foam carbon, or the like. When the foam metal is used as the positive electrode, the surface of the foam metal can be provided with no positive electrode film layers, and certainly, the foam metal can also be provided with a positive electrode film layer. As an example, the foam metal may also be filled or/and deposited with a lithium source material, potassium metal, or sodium metal, and the lithium source material is lithium metal and/or a lithium-rich material.

In some embodiments, the positive electrode film layer further optionally includes a positive electrode conductive agent. In the embodiments of the present application, the type of the positive electrode conductive agent is not particularly limited. As an example, the positive electrode conductive agent includes at least one of superconducting carbon, conductive graphite, acetylene black, carbon black, Ketjen black, a carbon dot, a carbon nanotube, graphene, and a carbon nanofiber. In some embodiments, the percentage by mass of the positive electrode conductive agent in the positive electrode film layer is ≤5 wt%.

In some embodiments, the positive electrode film layer further optionally includes a positive electrode binder. In the embodiments of the present application, the type of the positive electrode binder is not particularly limited. As an example, the positive electrode binder may include at least one of polyvinylidene difluoride (PVDF), polytetrafluoroethylene (PTFE), vinylidene fluoride-tetrafluoroethylene-propylene terpolymer, vinylidene fluoride-hexafluoropropylene-tetrafluoroethylene terpolymer, tetrafluoroethylene-hexafluoropropylene copolymer, and fluorinated acrylic resin. In some embodiments, the percentage by mass of the positive electrode binder in the positive electrode film layer is ≤5 wt%.

The positive electrode film layer is generally formed by coating a positive electrode current collector with a positive electrode slurry, drying, and cold pressing. The positive electrode slurry is generally formed by dispersing the positive electrode active material, an optional conductive agent, an optional binder, and any other components in a solvent and stirring them uniformly. The solvent may be N-methylpyrrolidone (NMP), but is not limited thereto.

In some embodiments, the negative electrode may be a negative electrode plate. The negative electrode plate may include a negative electrode current collector and a negative electrode film layer disposed on at least one surface of the negative electrode current collector, and the negative electrode film layer includes a negative electrode active material.

As an example, the negative electrode current collector has two surfaces opposite to each other in its own thickness direction, and the negative electrode film layer is disposed on any one or both of the two opposite surfaces of the negative electrode current collector.

As an example, the negative electrode current collector may be made of metal foil, foam metal, or composite current collector. For example, for the metal foil, aluminum or stainless steel treated with silver on the surface, stainless steel, copper, aluminum, nickel, carbon electrode, carbon, titanium, or the like may be used. The foam metal may be foam nickel, foam copper, foam aluminum, foam alloy, foam carbon, or the like. The composite current collector may include a polymer material substrate and a metal layer. The composite current collector may be fabricated by forming a metal material (copper, copper alloy, nickel, nickel alloy, titanium, titanium alloy, silver, silver alloy, etc.) on a polymer material substrate (such as a substrate made of polypropylene, polyethylene terephthalate, polybutylene terephthalate, polystyrene, and polyethylene).

As an example, the negative electrode active material for the battery cell 30 well known in the art may be used as the negative electrode active material. As an example, the negative electrode active material may include at least one of the following materials: a carbon material (such as a carbon material including at least one of artificial graphite, natural graphite, soft carbon, and hard carbon), a silicon-based material, a tin-based material, lithium titanate, and the like. The silicon-based material may include at least one of elemental silicon, a silicon-oxygen compound, a silicon-carbon composite, a silicon-nitrogen composite, and a silicon alloy. The tin-based material may include at least one of elemental tin, a tin-oxygen compound, and a tin alloy. However, the present application is not limited to these materials, and other traditional materials that can be used as negative electrode film layers for batteries may also be used. These negative electrode film layers may be used alone or in a combination of two or more.

In some embodiments, the negative electrode active material includes silicon element, which may be present in the form of a silicon-based material. For example, the silicon-based material may include at least one of elemental silicon, a silicon-oxygen compound, a silicon-carbon composite, a silicon-nitrogen composite, and a silicon alloy. The introduction of silicon element can improve the energy density of the battery cell 30.

In some embodiments, the silicon element is present in the negative electrode film layer in a content by mass of 1 wt% to 32 wt%, optionally 2 wt% to 19 wt%, and further optionally 6 wt% to 13 wt%. In a system of the battery cell 30, the content by mass of silicon element in the above range can improve the energy density of the battery cell 30.

In the embodiments of the present application, the content by mass of silicon element in the negative electrode film layer is a concept known in the art, and can be determined by using a device and a method known in the art, for example, by soaking the negative electrode plate in a solvent such as water, separating the negative electrode active material from the negative electrode current collector, filtering at reduced pressure to give the negative electrode active material, and analyzing the negative electrode active material on an inductively coupled plasma optical emission spectrometer (ICAP7400, Thermo Fisher Scientific, U.S.A) according to the GB/T30902-2014 to give the content of the silicon element.

In some embodiments, the negative electrode film layer further optionally includes a negative electrode conductive agent. In the embodiments of the present application, the type of the negative electrode conductive agent is not particularly limited. As an example, the negative electrode conductive agent may include at least one of superconducting carbon, conductive graphite, acetylene black, carbon black, Ketjen black, a carbon dot, a carbon nanotube, graphene, and a carbon nanofiber. In some embodiments, the percentage by mass of the negative electrode conductive agent in the negative electrode film layer is ≤5 wt%.

In some embodiments, the negative electrode film layer further optionally includes a negative electrode binder. In the embodiments of the present application, the type of the negative electrode binder is not particularly limited. As an example, the negative electrode binder may include at least one of styrene-butadiene rubber (SBR), water-soluble unsaturated resin SR-1B, aqueous acrylic resin (e.g., polyacrylic acid PAA, polymethacrylic acid PMAA, or sodium polyacrylate PAAS), polyacrylamide (PAM), polyvinyl alcohol (PVA), sodium alginate (SA), and carboxymethyl chitosan (CMCS). In some embodiments, the percentage by mass of the negative electrode binder in the negative electrode film layer is ≤5%.

In some embodiments, the negative electrode film layer further optionally includes other auxiliary agents. As an example, other auxiliary agents may include thickeners, such as sodium carboxymethylcellulose (CMC-Na) or PTC thermistor materials. In some embodiments, the percentage by mass of the other auxiliary agent in the negative electrode film layer is ≤2 wt%.

In some embodiments, the material of the positive electrode current collector may be aluminum, and the material of the negative electrode current collector may be copper.

In some embodiments, the separator includes a separation film. In the present application, the type of the separation film is not particularly limited, and any porous-structure separation film known to have good chemical stability and mechanical stability may be selected and used.

In the embodiments of the present application, the type of the separation film is not particularly limited, and any porous-structure separation film known to have good chemical stability and mechanical stability may be selected and used.

In some embodiments, the separation film may be made of a material including one or more of glass fiber, non-woven fabric, polyethylene, polypropylene, and polyvinylidene difluoride. The separation film may be a single-layer film or a multi-layer composite film, which is not particularly limited. When the separation film is a multi-layer composite film, the materials of the layers may be identical or different, which is not particularly limited.

In some embodiments, the separation film may include a porous substrate film and a coating layer disposed on at least one side of the porous substrate film, and the coating layer may include at least one of an inorganic particle or an organic particle.

The porous substrate film may include one or more of polyethylene and polypropylene.

The inorganic particle has better heat resistance, and can improve the overall heat resistance of the separation film. The inorganic particle is substantially unreactive to oxidation or reduction with the metal dendrites over the operating voltage range of the sodium-ion battery. In other words, the inorganic particles are configured unreactive to the oxidation and reduction with an alkali metal and/or alkaline earth metal at the nominal voltage of the sodium-ion battery.

In some embodiments, the inorganic particle includes one or more of boehmite γ-AlOOH, aluminum oxide Al₂O₃, aluminum hydroxide Al(OH)₃, barium sulfate BaSO₄, magnesium oxide MgO, magnesium hydroxide Mg(OH)₂, calcium oxide CaO, cerium oxide CeO₂, zirconium titanate SrTiO₃, barium titanate BaTiO₃, and magnesium fluoride MgF₂.

In some embodiments, the organic particle includes at least one of polystyrene, polyethylene, polyimide, melamine resin, phenolic resin, polypropylene, polyester (e.g., polyethylene terephthalate, polyethylene naphthalate, polybutylene terephthalate), polyphenylene sulfide, polyaramide, polyamideimide, polyimide, copolymer of butyl acrylate and ethyl methacrylate, and a mixture thereof.

In some embodiments, the battery cell 30 further includes an electrolytic solution.

During the charging and discharging process of the battery cell, active ions are intercalated and deintercalated back and forth between the positive electrode plate and the negative electrode plate, and the electrolytic solution plays a role in conducting the active ions between the positive electrode plate and the negative electrode plate. In the embodiments of the present application, the type of the electrolytic solution is not particularly limited, and can be selected according to actual requirements.

The electrolytic solution includes an electrolyte salt and a solvent. The types of the electrolyte salt and the solvent are not particularly limited, and can be selected according to actual requirements.

In some embodiments, the electrolytic solution further optionally includes an additive. For example, the additive may include a negative electrode film-forming additive, or may include a positive electrode film-forming additive, or may include an additive capable of improving certain properties of the battery, such as an additive for improving the overcharge performance of the battery, an additive for improving the high-temperature performance of the battery, or an additive for improving the low-temperature power performance of the battery.

For example, the additive includes at least one of a cyclic carbonate compound, a sulfate compound, a sulfite compound, a sultone compound, a disulfonic acid compound, a nitrile compound, an aromatic compound, an isocyanate compound, a phosphazene compound, an acid anhydride, a cyclic acid anhydride compound, a phosphite compound, a phosphate compound, a borate, and a carboxylate compound, having an unsaturated bond.

It will be appreciated that, when the battery cell 30 is a lithium iron phosphate battery cell, in the positive electrode material of the battery cell 30, on the basis of the total weight of the positive electrode material, the positive electrode active material accounts for 96 parts by weight, the binder accounts for 1 to 3 parts by weight (for example, but not limited to, 1, 1.2, 1.5, 1.8, 2, 2.2, 2.5, 2.8, 3, etc.), and the conductive agent accounts for 1 to 3 parts by weight (for example, but not limited to, 1, 1.2, 1.5, 1.8, 2, 2.2, 2.5, 2.8, 3, etc.).

Illustratively, when the battery cell 30 is a lithium iron phosphate battery cell, the positive electrode active material is LFP (which may refer to LiFePO₄, i.e., lithium iron phosphate), the binder may be PVDF (polyvinylidene difluoride), and the conductive agent may be conductive carbon black, where LFP:PVDF:conductive carbon black may be 96:2:2, that is, dividing the total weight of the positive electrode active material into 100 parts, LFP accounts for 96 parts, PVDF accounts for 2 parts, and the conductive carbon black accounts for 2 parts. The unit of weight for the positive electrode active material may be gram.

When the battery cell 30 is a ternary battery cell, in the positive electrode material of the battery cell 30, on the basis of the total weight of the positive electrode material, the positive electrode active material accounts for 96 parts by weight, the binder accounts for 2 to 3 parts by weight (for example, but not limited to, 2, 2.2, 2.5, 2.8, 3, etc.), and the conductive agent accounts for 1 to 2 parts by weight (for example, but not limited to, 1, 1.2, 1.5, 1.8, 2, etc.). The ternary battery cell may be, but is not limited to, a lithium nickel cobalt manganese oxide system, a lithium nickel cobalt aluminum oxide system, and the like.

Illustratively, the ternary material of the ternary battery cell may be an eight-series LiNi_{0.8}Co_{0.1}Mn_{0.1}O₂, and the ratio of the positive electrode active material, the binder, and the conductive agent in parts by weight is 96:2.5:1.5, that is, that is, dividing the total weight of the positive electrode material into 100 parts, the eight-series LiNi_{0.8}Co_{0.1}Mn_{0.1}O₂ accounts for 96 parts, the binder accounts for 2.5 parts, and the conductive agent accounts for 1.5 parts.

In the above technical solution, when the battery cell 30 is a lithium iron phosphate battery cell, the high proportion of the positive electrode active material means that a greater amount of the substances for the electrochemical reaction may be contained in a limited electrode assembly, which is beneficial to increasing the capacity and the energy density of the battery device 100, such that the lithium iron phosphate battery cell can output a higher power in the condition of a relatively small volume and weight, thus satisfying an application scene with a certain requirement on the energy density. The amounts of the binder and the conductive agent within the above ranges can improve the cost-efficiency of the auxiliary materials, thereby improving the overall cost-efficiency of the battery device 100. When the battery cell 30 is a ternary battery cell, due to the fact that the structure and surface properties of the ternary material are relatively complicated, the positive electrode active material, the binder, and the conductive agent in the above amount ratio may ensure a good adhesion among the positive electrode active material particles and between the active material and the current collector, thus improving the mechanical stability and integrity of the electrode assembly, reducing the risk of falling-off of the active material and electrode pulverization in the charging and discharging process, and prolonging the cycle life of the battery device 100.

In a second aspect, as shown in FIG. 1, the embodiments of the present application provide an electric device, including the battery device 100 according to any one of the above embodiments, where the battery device 100 is configured for providing electric energy.

The electric device may be the vehicle 1000, and the battery device 100 may be mounted at the bottom of the vehicle.

In the electric device of the technical solution of the present application, at least two adjacent second sampling parts 82 can acquire parameters of two or more battery cells, such that the total number of the sampling parts (including the first sampling parts 81 and the second sampling parts 82) can be correspondingly reduced, and the connection wire harness 70 can be shortened and simplified, thereby making the battery device 100 more compact, saving space, and improving the energy density of the battery device 100 and cost-efficiency to a certain extent.

Finally, it should be noted that the above embodiments are only used to illustrate the technical solutions of the present application, rather than limiting same. Although the present application has been described in detail with reference to the foregoing embodiments, those of ordinary skill in the art will appreciate that modifications can still be made to the technical solutions recorded in the foregoing embodiments, or equivalent substitutions to some or all of the technical features. However, such modifications or substitutions do not make the spirit of the corresponding technical solutions deviate from the scope of the technical solutions in the embodiments of the present application, and shall all fall within the scope of claims and specification of the present application. In particular, the technical features mentioned in the embodiments may be combined in any manner as long as there are no structural conflicts. The present application is not limited to the specific embodiments disclosed herein, but encompasses all technical solutions falling within the scope of the claims.

## Claims

1. A battery device, comprising:
a battery cell assembly, comprising a plurality of battery cells sequentially connected in series;
a sampling assembly, comprising a plurality of sampling parts, a plurality of connection wire harnesses, and an output port, wherein each sampling part is electrically connected to at least one connection wire harness, a plurality of the connection wire harnesses are all connected to the output port, the plurality of sampling parts comprise a first sampling part and a second sampling part, and the first sampling part and the second sampling part are provided with a sampling point that can be electrically connected to the series path of the battery cells; the number of the first sampling parts is two, and the two first sampling parts are separately and electrically connected to the battery cell at the front and the battery cell at the rear of a plurality of the battery cells sequentially connected in series; in the series path of a plurality of the battery cells, the number of the battery cells between the sampling points of at least two adjacent second sampling parts is greater than or equal to two.

2. The battery device according to claim 1 or 2, wherein in the series path of a plurality of the battery cells, the number of the battery cells between the sampling points of every two adjacent second sampling parts is equal, and is greater than or equal to two.

3. The battery device according to claim 1, wherein in the series path of a plurality of the battery cells, one or more of the battery cells are provided between the sampling point of the first sampling part and the sampling point of the adjacent second sampling part.

4. The battery device according to any one of claims 1-3, wherein a plurality of the battery cells are arranged in a first direction to form a battery row; the battery cell assembly comprises at least one battery row; the sampling points of the two first sampling parts are separately located on two sides of the battery cell assembly in a second direction; the sampling points of the second sampling parts are distributed on the same side or different sides of the battery row in the second direction; the second direction and the first direction form an included angle.

5. The battery device according to claim 4, wherein a plurality of battery rows are present, a plurality of the battery rows are arranged in the second direction and/or a third direction, and the sampling points of the second sampling parts are distributed at least on one side of one of the battery rows in the arrangement direction thereof; every two of the first direction, the second direction, and the third direction form an included angle.

6. The battery device according to claim 5, wherein the number of the battery rows is two, and the two battery rows are arranged in the second direction; the sampling points of the second sampling parts are distributed between the two battery rows.

7. The battery device according to claim 5, wherein the number of the battery rows is two, and the two battery rows are arranged in the second direction; the sampling points of the second sampling parts are distributed on the two sides of one of the battery rows in the second direction.

8. The battery device according to any one of claims 1-7, wherein the connection wire harness is at least one of a flexible circuit board and a wire harness.

9. The battery device according to any one of claims 1-8, wherein the battery device comprises a battery monitoring unit; each of the battery cells is electrically connected to the battery monitoring unit through the connection wire harness; the connection wire harness comprises a first end part and a second end part that are opposite; the first end part forms the sampling part, and the second end part is electrically connected to the battery monitoring unit.

10. The battery device according to claim 9, wherein the second end part and the battery monitoring unit are connected by welding.

11. The battery device according to claim 9, wherein the second end part is connected to the output port; the battery monitoring unit is provided with a connector, and the output port is connected to the connector by means of plug-in.

12. The battery device according to claim 11, wherein the battery device comprises an electrical connection member, a first patch cable, and a second patch cable; the first patch cable and the second patch cable are both connected to the electrical connection member; the second end parts of a plurality of the conductive members are connected to the electrical connection member through the corresponding first patch cable, and the end of the second patch cable distal to the electrical connection member is connected to the output port and connected to the battery monitoring unit by means of plug-in.

13. The battery device according to any one of claims 9-12, wherein a plurality of the battery cells are arranged in the first direction to form the battery row; the number of the battery rows is at least two, and at least two of the battery rows are arranged in the second direction; the battery monitoring unit is disposed on one side of all the battery rows or between two adjacent battery rows in the second direction; the first direction and the second direction are disposed with an included angle.

14. The battery device according to claim 13, wherein the battery cell comprises a housing and conductive parts; the conductive parts are provided at end parts of the housing in the second direction, and the conductive parts of two adjacent battery cells in the second direction are connected; the first end part is connected to a part of the conductive parts to form the sampling part.

15. The battery device according to claim 14, wherein the first end part is welded or bonded to the conductive part.

16. The battery device according to claim 13 or 14, wherein a corner space is formed at a corner of the housing in the third direction; the connection wire harness is at least partially located in the corner space and extends in the second direction; every two of the first direction, the second direction, and the third direction are disposed with an included angle.

17. The battery device according to any one of claims 14-16, wherein all the conductive parts located on the same side of a plurality of the battery cells of the battery cell assembly are sequentially arranged in the first direction; in the third direction, a plurality of the conductive parts and the end part of the battery cell assembly form an accommodating gap, and the battery monitoring unit is disposed in the accommodating gap.

18. The battery device according to claim 17, wherein the battery device comprises the electrical connection member; the electrical connection member is disposed in the accommodating gap, located between the conductive part and the battery monitoring unit, and electrically connected to the battery monitoring unit and the conductive part.

19. The battery device according to any one of claims 9-17, wherein the battery device comprises a master control board, and the battery monitoring unit is electrically connected to the master control board.

20. The battery device according to any one of claims 17-19, wherein the battery device comprises a case comprising a bottom plate, and the accommodating gap is located between the bottom plate and the conductive part.

21. The battery device according to claim 20, wherein the battery device comprises a support connected to the case, and the battery monitoring unit is mounted to the support.

22. The battery device according to claim 20, wherein the battery monitoring unit is bonded to a case wall of the case.

23. The battery device according to any one of claims 17-22, wherein the length of the battery monitoring unit extends in the first direction.

24. The battery device according to any one of claims 14-23, wherein the housing is made of a soft outer packaging material; in the first direction, a reinforcing partition plate is sandwiched between at least two adjacent battery cells and connected to the housing; the hardness of the reinforcing partition plate is greater than that of the housing.

25. The battery device according to claim 24, wherein the thickness of the reinforcing partition plate is less than that of the battery cell.

26. The battery device according to claim 24 or 25, wherein the reinforcing partition plate is a metal plate.

27. The battery device according to any one of claims 24-26, wherein the reinforcing partition plate is a thermally conductive member and is thermo-conductively connected to the housing.

28. The battery device according to any one of claims 24-27, wherein the reinforcing partition plate is of a solid structure.

29. The battery device according to any one of claims 24-27, wherein a cavity is formed in the reinforcing partition plate.

30. The battery device according to claim 29, wherein the cavity comprises a heat exchange flow channel for the flow of a heat exchange medium.

31. The battery device according to any one of claims 24-30, wherein the reinforcing partition plate comprises a connecting part protruding from the housing in the second direction, and the connecting part is located on the side of the conductive part distal to the battery monitoring unit.

32. The battery device according to any one of claims 24-31, wherein in the first direction, two adjacent reinforcing partition plates are connected by a connecting plate, and the battery cell is accommodated in a space defined by the connecting plate and the two reinforcing partition plates in an enclosing manner.

33. The battery device according to claim 32, wherein the two adjacent reinforcing partition plates in the first direction, along with the connecting plate connected thereto, are integrally formed.

34. The battery device according to any one of claims 14-33, wherein the conductive parts of the two adjacent battery cells are directly connected.

35. The battery device according to claim 34, wherein the conductive parts of the two adjacent battery cells are connected by welding.

36. The battery device according to claim 34, wherein the conductive parts of the two adjacent battery cells are directly connected by a conductive adhesive.

37. The battery device according to any one of claims 14-36, wherein a plurality of the battery cells are sequentially coupled by bonding in the first direction; the battery cell is provided with a first surface and a second surface, and the second surface is adjacent to the first surface;
the battery device comprises the case, an adhesive layer, and a blocking member; the adhesive layer is arranged on the side of the first surface of the battery cell assembly and configured for bonding a plurality of the battery cells to the case; the blocking member is at least located between at least one of the battery cells at the two ends of the battery cell assembly in the first direction and the adhesive layer, and configured for preventing the adhesive layer from overflowing from the first surface of the battery cell to the second surface of the corresponding battery cell.

38. The battery device according to claim 37, wherein the blocking member covers at least a corner position of the corresponding battery cell.

39. The battery device according to claim 37, wherein the blocking member covers at least an edge position of the corresponding battery cell in the first direction.

40. The battery device according to claim 37, wherein one of the blocking members is disposed between two adjacent battery cells in the first direction.

41. The battery device according to any one of claims 1-41, wherein the battery cell is any one of a lithium iron phosphate battery cell, a ternary battery cell, and a solid-state battery cell.

42. The battery device according to any one of claims 1-41, wherein the battery cell is a lithium iron phosphate battery cell, and in the positive electrode material of the battery cell, the ratio of a positive electrode active material, a binder, and a conductive agent is 96:(1-3):(1-3); the battery cell is a ternary battery cell, and in the positive electrode material of the battery cell, the ratio of a positive electrode active material, a binder, and a conductive agent is 96:(2-3):(1-2).

43. An electric device, comprising the battery device according to any one of claims 1-42, wherein the battery device is configured for providing electric energy.
